# EUROPÄISCHE PATENTSCHRIFT

(11) **EP 2 941 470 B1**
(45) Veröffentlichungstag und Bekanntmachung des Hinweises auf die Patenterteilung: **05.09.2018**
(21) Anmeldenummer: 13801989.8
(22) Anmeldetag: 09.12.2013
(51) Int. Cl.: C09K 11/06, H05B 33/14, H01L 51/50, H01L 51/00

(54) **ELEKTRONISCHE VORRICHTUNG**
ELECTRONIC DEVICE
DISPOSITIF ÉLECTRONIQUE

(30) Priorität: 03.01.2013 EP 13000014
(43) Veröffentlichungstag der Anmeldung: 11.11.2015
(73) Patentinhaber: Merck Patent GmbH, 64293 Darmstadt (DE)
(72) Erfinder: PFLUMM, Christof, 64291 Darmstadt (DE); VOGES, Frank, 67098 Bad Duerkheim (DE); KROEBER, Jonas Valentin, 60311 Frankfurt am Main (DE); STOESSEL, Philipp, 60487 Frankfurt am Main (DE); HEIL, Holger, 60389 Frankfurt am Main (DE)
(86) Internationale Anmeldenummer: PCT/EP2013/003717
(87) Internationale Veröffentlichungsnummer: WO 2014/106523

(56) Entgegenhaltungen:
- WO-A1-2006/117052
- WO-A2-2005/020283
- US-A1- 2009 146 552
- US-A1- 2011 018 429
- US-A1- 2012 187 826

## Beschreibung

Die vorliegende Erfindung betrifft eine elektronische Vorrichtung, welche eine emittierende Schicht mit einer definierten Zusammensetzung verschiedener Verbindungen enthält.

Unter elektronischen Vorrichtungen im Sinne dieser Anmeldung werden insbesondere sogenannte organische elektronische Vorrichtungen verstanden (organic electronic devices), welche organische Halbleitermaterialien als Funktionsmaterialien enthalten. Nochmals insbesondere werden darunter organische Elektrolumineszenzvorrichtungen (OLEDs) und andere elektronische Vorrichtungen verstanden, welche weiter unten aufgeführt sind.

Der Aufbau von OLEDs, in denen organische Halbleiter als funktionelle Materialien eingesetzt werden, ist beispielsweise in US 4539507, US 5151629, EP 0676461 und WO 98/27136 beschrieben. Allgemein werden unter der Bezeichnung OLED elektronische Vorrichtungen verstanden, welche organisches Material enthalten und unter Anlegen einer elektrischen Spannung Licht emittieren.

Bei elektronischen Vorrichtungen, insbesondere OLEDs, besteht großes Interesse an der Verbesserung der Leistungsdaten, insbesondere Lebensdauer und Effizienz. In beiden Punkten konnte insbesondere bei blau emittierenden OLEDs noch keine vollständig zufriedenstellende Lösung gefunden werden.

Um in diesen Punkten weitere Fortschritte zu erreichen, wird besonderes Augenmerk auf die Zusammensetzung der emittierenden Schicht gerichtet.

Im Stand der Technik ist bereits seit Langem bekannt, dass durch Verwendung von mehr als einer einzigen Verbindung in der emittierenden Schicht die Effizienz einer OLED deutlich gesteigert werden kann. Im einzelnen wird bei dieser technischen Lösung eine Dotandverbindung in Kombination mit einer zweiten Verbindung, die als Matrixverbindung dient, also in überwiegendem Anteil vorliegt, in der emittierenden Schicht eingesetzt. Solche Ausführungsformen wurden für fluoreszierende emittierende Schichten unter anderem in US 4769292, US 5908581, US 5593788 und US 5141671 beschrieben.

Weiterhin wird in einigen Publikationen beschrieben, drei unterschiedliche Verbindungen in der emittierenden Schicht einer OLED einzusetzen.

Beispielsweise wird in EP 1227527 eine OLED enthaltend die beiden Verbindungen Tris-(8-Hydroxychinolin)-Aluminium (Alq₃) und N,N'-Di-1-Naphthyl-N,N'-diphenyl-1,1'-biphenyl-4,4'-diamin (NPB) als Hostmaterialien sowie als Dotand Rubren offenbart.

In US 2011/018429 wird eine OLED enthaltend in der emittierenden Schicht ein Anthracen-Matrixmaterial, einen Dotanden und optional ein weiteres Matrixmaterial offenbart, wobei das weitere Matrixmaterial unter anderem ein tertiäres Amin darstellen kann.

US 2009/146552 und WO 2005/020283 offenbaren OLEDs enthaltend in der emittierenden Schicht ein Anthracen-Matrixmaterial, einen Dotanden und ein weiteres Matrixmaterial, welche zwei Aminogruppen aufweist.

In US 2012/187826 wird eine OLED offenbart, die in der emittierenden Schicht Perylen und einen Dotanden, der bevorzugt aus Triarylaminen gewählt ist, und optional ein weiteres Matrixmaterial enthält.

Weiterhin wird in US 7504163 eine OLED enthaltend ein Anthracenderivat (2-Tertbutyl-9,10-bis(2-naphthalenyl)anthracen) als Hostmaterial, einen Borkomplex oder ein Perylenderivat als Dotand, sowie 1-5 % NPB als weitere Komponente offenbart. Dadurch wurde eine erhöhte Effizienz gegenüber einer OLED, die kein NPB als weitere Komponente der emittierenden Schicht enthält, erreicht.

Es besteht jedoch weiterhin Interesse an OLEDs, welche erhöhte Effizienz und lange Lebensdauer aufweisen, inbesondere an blau fluoreszierenden OLEDs mit diesen Eigenschaften.

Im Rahmen der vorliegenden Erfindung wurde überraschend gefunden, dass durch Verwendung eines Triaryl-Monoamins in einer emittierenden Schicht enthaltend einen Dotanden sowie ein Matrixmaterial enthaltend mindestens eine Anthracen-Einheit oder mindestens eine Pyren-Einheit die Effizienz und die Lebensdauer der Vorrichtung gesteigert werden kann.

Weiterhin sind die verwendeten Monoamine einfach herzustellen und aufzureinigen und somit wirtschaftlich günstig.

Gegenstand der vorliegenden Anmeldung ist somit eine elektronische Vorrichtung, enthaltend Anode, Kathode, sowie mindestens eine emittierende Schicht, wobei die emittierende Schicht mindestens einen Dotanden D, mindestens ein Matrixmaterial M1 und mindestens ein Matrixmaterial M2 enthält, wobei D, M1 und M2 unterschiedlich gewählt sind und wobei M1 gewählt ist aus Mono-Triarylaminen und M2 gewählt ist aus Verbindungen enthaltend mindestens eine Anthraceneinheit oder aus Verbindungen enthaltend mindestens eine Pyreneinheit, und wobei M1 keine kondensierte Arylgruppe mit mehr als 10 aromatischen Ringatomen enthält.

Die erfindungsgemäße elektronische Vorrichtung weist den Vorteil auf, dass sie eine hohe Betriebs-Lebensdauer hat. Weiterhin weist sie eine hohe Leistungseffizienz auf. Nochmals weiterhin weist sie eine hohe Farbreinheit, inbesondere bei blauer Emission, auf.

Im Rahmen dieser Anmeldung wird unter einem Mono-Triarylamin eine Verbindung verstanden, welche eine einzige Triarylamingruppe aufweist. Eine Triarylamingruppe ist eine Gruppe, in der drei aromatische oder heteroaromatische Ringsysteme an ein gemeinsames Stickstoffatom gebunden sind. Bevorzugt enthält eine Mono-Triarylaminverbindung keine weitere Arylaminogruppe. Besonders bevorzugt enthält eine Mono-Triarylaminverbindung keine weitere Aminogruppe.

Das Matrixmaterial M1 ist bevorzugt gewählt aus Mono-Triarylamin-Verbindungen, bei denen drei aromatische Ringsysteme an ein gemeinsames Stickstoffatom gebunden sind. Die aromatischen Ringsysteme haben bevorzugt 6 bis 50 aromatische Ringatome und können substituiert oder unsubstituiert sein. Sie enthalten bevorzugt keine Aminogruppe als Substituent. Weiterhin enthält M1 bevorzugt kein kondensierte Heteroarylgruppe mit mehr als 14 aromatischen Ringatomen, besonders bevorzugt keine kondensierte Heteroarylgruppe mit mehr als 10 aromatischen Ringatomen.

Unter einer kondensierten Arylgruppe wird dabei eine Arylgruppe verstanden, welche zwei oder mehr aromatische Ringe enthält, die miteinander kondensiert sind, d. h. eine oder mehr aromatische Bindungen miteinander teilen. Eine entsprechende Definition gilt für Heteroarylgruppen. Beispiele für kondensierte Arylgruppen sind Naphthyl, Anthracenyl, Pyrenyl, Phenanthrenyl und Perylenyl. Beispiele für kondensierte Heteroarylgruppen sind Chinolinyl, Indolyl, Carbazolyl, und Acridinyl.

Besonders bevorzugt ist M1 gewählt aus Verbindungen der Formel (I) 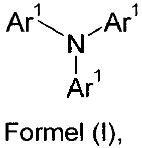 wobei gilt:
- Ar¹: ist bei jedem Auftreten gleich oder verschieden ein aromatisches oder heteroaromatisches Ringsystem mit 5 bis 50 aromatischen Ringatomen, das mit einem oder mehreren Resten R¹ substituiert sein kann; und
- R¹: ist bei jedem Auftreten gleich oder verschieden H, D, F, C(=O)R², CN, Si(R²)₃, P(=O)(R²)₂, S(=O)R², eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten R² substituiert sein können und wobei eine oder mehrere CH₂-Gruppen in den oben genannten Gruppen durch -R²C=CR²-, -C≡C-, Si(R²)₂, C=O, C=S, C=NR², -C(=O)O-, -C(=O)NR²-, P(=O)(R²), -O-, -S-, SO oder SO₂ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste R² substituiert sein kann, oder eine Aryloxy- oder Heteroaryloxygruppe mit 5 bis 30 aromatischen Ringatomen, die durch einen oder mehrere Reste R² substituiert sein kann, wobei zwei oder mehr Reste R¹ miteinander verknüpft sein können und einen Ring bilden können;
- R²: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R² miteinander verknüpft sein und einen Ring bilden.

Ar¹ ist bevorzugt ein aromatisches Ringsystem mit 6 bis 30 aromatischen Ringatomen, das mit einem oder mehreren Resten R¹ substituiert sein kann. Besonders bevorzugt enthält Ar¹ eine mit R¹ substituierte oder unsubstituierte Gruppe gewählt aus Fluoren, Indenofluoren, Spirobifluoren, Phenyl, Biphenyl, Terphenyl oder Naphthyl.

Weiterhin bevorzugt umfasst Ar¹ keine kondensierte Heteroarylgruppe mit mehr als 14 aromatischen Ringatomen, besonders bevorzugt umfasst Ar¹ keine kondensierte Heteroarylgruppe mit mehr als 10 aromatischen Ringatomen.

Bevorzugt ist M1 gewählt aus Verbindungen der Formeln (I-1) bis (I-6) 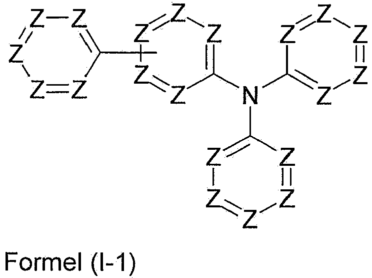 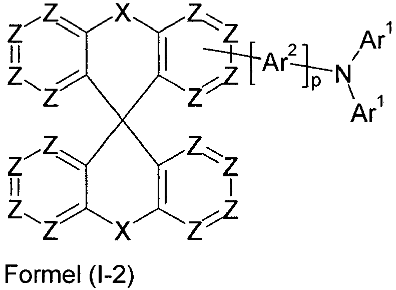 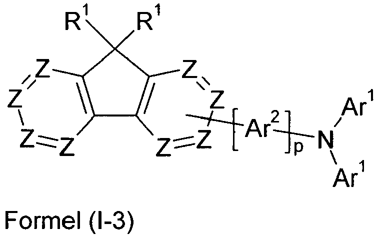 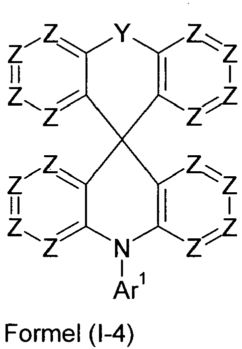 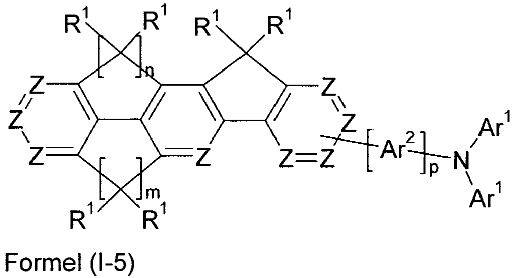 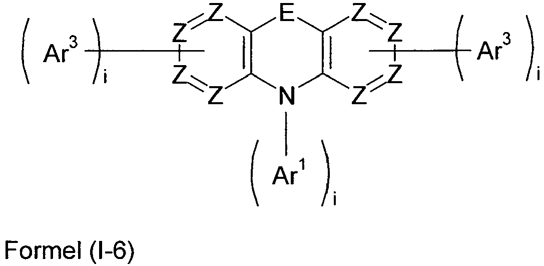 enthält, wobei gilt:
- Z: ist bei jedem Auftreten gleich oder verschieden N oder CR¹, wobei Z gleich C ist, wenn ein Substituent gebunden ist;
- X: ist bei jedem Auftreten gleich oder verschieden eine Einfachbindung, O, S, Se, BR¹, C(R¹)₂, Si(R¹)₂, NR¹, PR¹, C(R¹)₂-C(R¹)₂, oder CR¹=CR¹;
- Y: ist eine Einfachbindung, O, S, Se, BR¹, C(R¹)₂, Si(R¹)₂, NR¹, PR¹, C(R¹)₂-C(R¹)₂, oder CR¹=CR¹;
- E: ist O, S, Se, BR¹, C(R¹)₂, Si(R¹)₂, NR¹, PR¹, C(R¹)₂-C(R¹)₂, oder CR¹=CR¹;
- Ar¹: ist definiert wie oben;
- Ar², Ar³: ist ein aromatisches oder heteroaromatisches Ringsystem mit 6 bis 18 aromatischen Ringatomen, das mit einem oder mehreren Resten R¹ substituiert sein kann;
- R¹ , R²: sind definiert wie oben;
- i: ist bei jedem Auftreten gleich oder verschieden 0 oder 1, wobei die Summe aller i mindestens gleich 1 ist;
- p: ist gleich 0 oder 1;
- m, n: sind gleich oder verschieden 0 oder 1, wobei die Summe aus m und n gleich 1 oder 2 ist.

Für die oben genannten Formeln (I-1) bis (I-6) gilt bevorzugt, dass nicht mehr als drei Gruppen Z in einem Ring gleich N sind. Es ist allgemein bevorzugt, dass Z gleich CR¹ ist.

Die Gruppe X ist bei jedem Auftreten bevorzugt gleich oder verschieden gewählt aus einer Einfachbindung, C(R¹)₂, O und S, besonders bevorzugt ist sie eine Einfachbindung.

Die Gruppe Y ist bevorzugt gewählt aus O und C(R¹)₂, besonders bevorzugt ist sie O.

Die Gruppe E ist bevorzugt gewählt aus C(R¹)₂, O und S, besonders bevorzugt ist sie C(R¹)₂.

Die Gruppe Ar¹ ist bevorzugt bei jedem Auftreten gleich oder verschieden gewählt aus aromatischen oder heteroaromatischen Ringsystemen mit 6 bis 30 aromatischen Ringatomen, die mit einem oder mehreren Resten R¹ substituiert sein können. Besonders bevorzugt ist Ar¹ gewählt aus Aryl- oder Heteroarylgruppen mit 6 bis 18 aromatischen Ringatomen, die mit einem oder mehreren Resten R¹ substituiert sein können.

R¹ ist bevorzugt bei jedem Auftreten gleich oder verschieden H, D, F, CN, Si(R³)₃, eine geradkettige Alkyl- oder Alkoxygruppe mit 1 bis 20 C-Atomen oder eine verzweigte oder cyclische Alkyl- oder Alkoxygruppe mit 3 bis 20 C-Atomen, wobei die oben genannten Gruppen jeweils mit einem oder mehreren Resten R³ substituiert sein können und wobei in den oben genannten Gruppen eine oder mehrere CH₂-Gruppen durch -C=C-,-R³C=CR³-, Si(R³)₂, C=O, C=NR³, -O-, -S-, -C(=O)O- oder -C(=O)NR³- ersetzt sein können, oder ein aromatisches oder heteroaromatisches Ringsystem mit 5 bis 20 aromatischen Ringatomen, das jeweils mit einem oder mehreren Resten R² substituiert sein kann, wobei zwei oder mehr Reste R¹ miteinander verknüpft sein können und einen Ring bilden können.

Beispiele für Verbindungen, die als Matrixmaterial M1 in der erfindungsgemäßen elektronischen Vorrichtung eingesetzt werden, sind im Folgenden aufgeführt:

| | | |
|---|---|---|
| 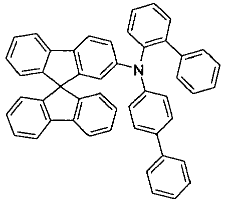 | 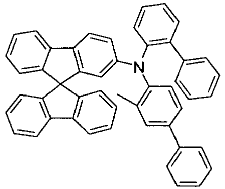 | 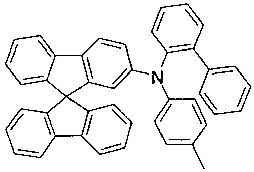 |
| 1 | 2 | 3 |
| 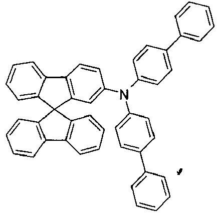 | 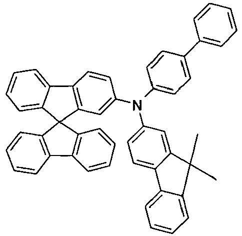 | 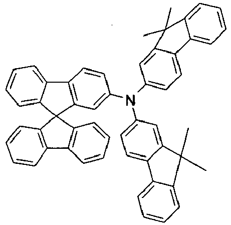 |
| 4 | 5 | 6 |
| 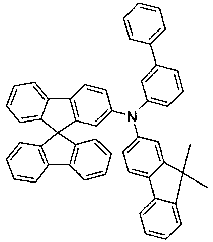 | 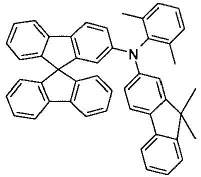 | 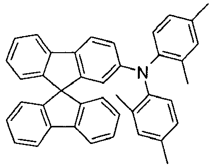 |
| 7 | 8 | 9 |
| 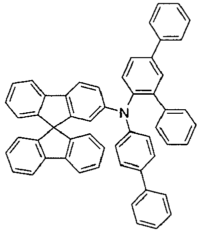 | 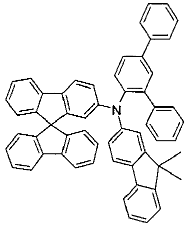 | 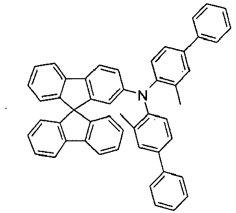 |
| 10 | 11 | 12 |
| 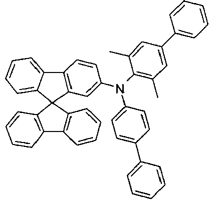 | 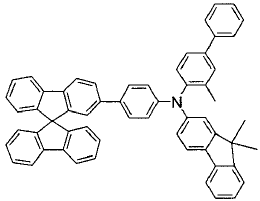 | 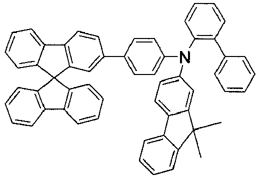 |
| 13 | 14 | 15 |
| 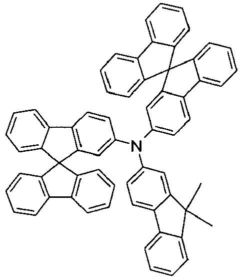 | 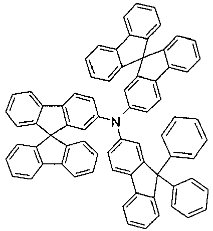 | 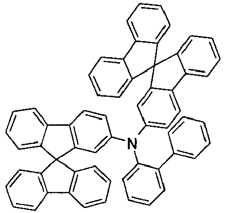 |
| 16 | 17 | 18 |
| 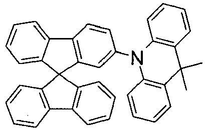 | 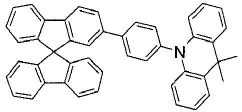 | 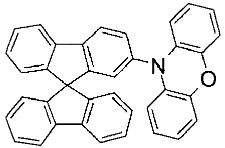 |
| 19 | 20 | 21 |
| 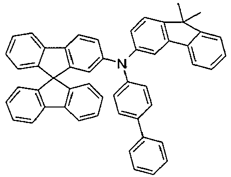 | 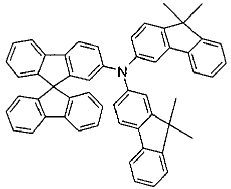 | 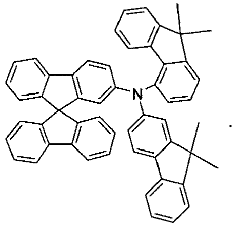 |
| 22 | 23 | 24 |
| 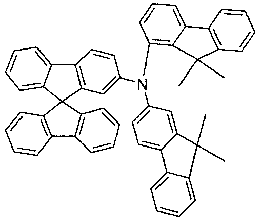 | 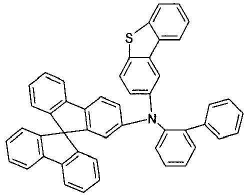 | 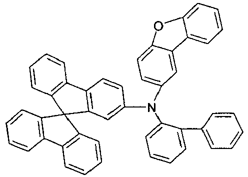 |
| 25 | 26 | 27 |
| 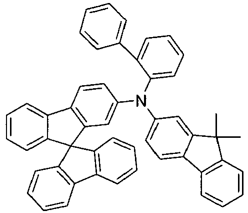 | 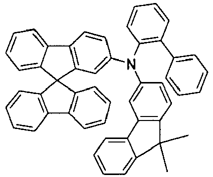 | 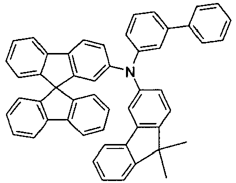 |
| 28 | 29 | 30 |
| 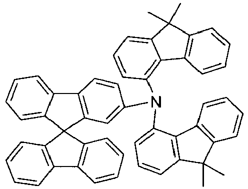 | 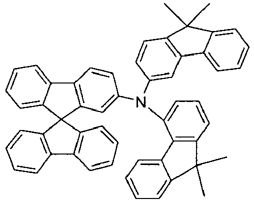 | 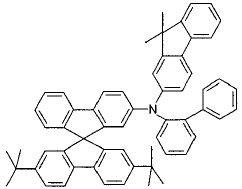 |
| 31 | 32 | 33 |
| 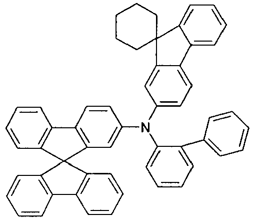 | 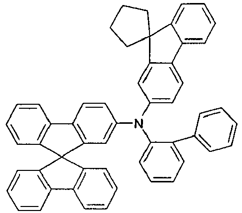 | 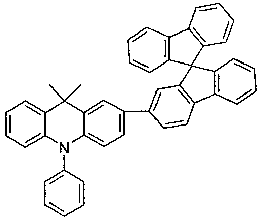 |
| 34 | 35 | 36 |
| 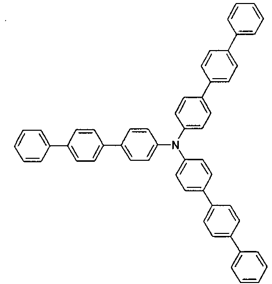 | 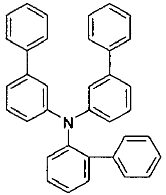 | 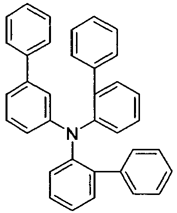 |
| 37 | 38 | 39 |
| 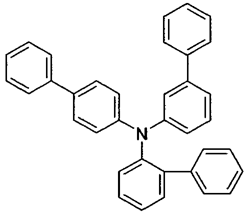 | 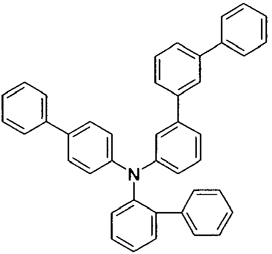 | 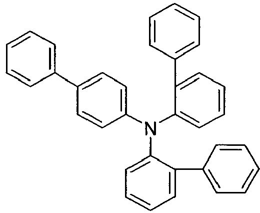 |
| 40 | 41 | 42 |
| 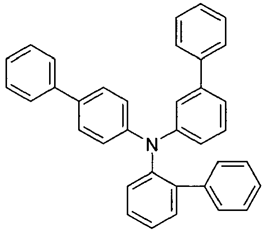 | 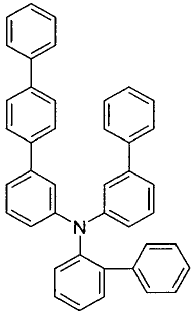 | 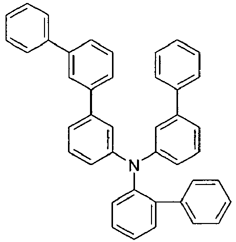 |
| 43 | 44 | 45 |
| 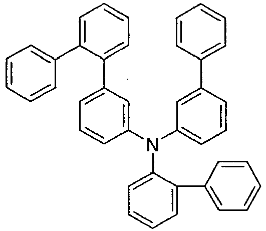 | 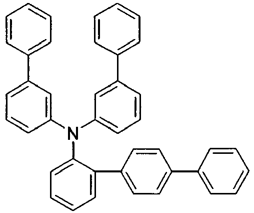 | 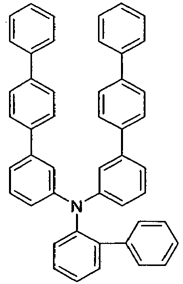 |
| 46 | 47 | 48 |
| 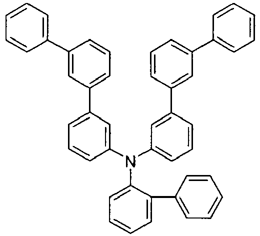 | 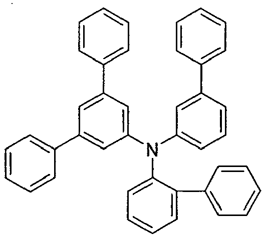 | 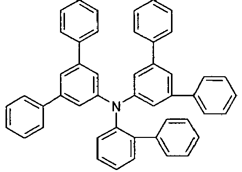 |
| 49 | 50 | 51 |
| 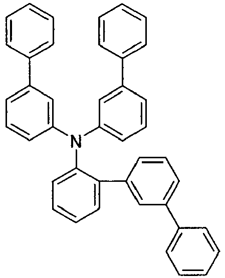 | 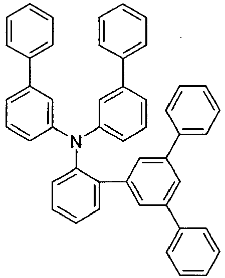 | 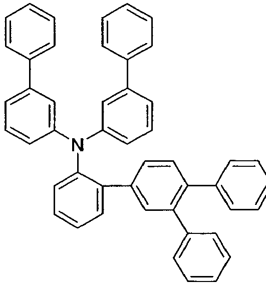 |
| 52 | 53 | 54 |
| 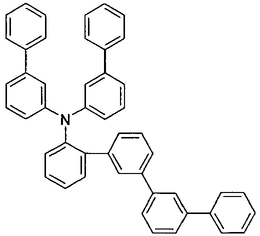 | 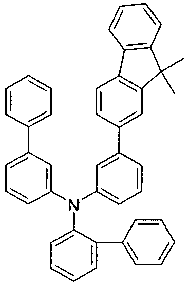 | 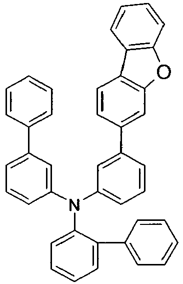 |
| 55 | 56 | 57 |
| 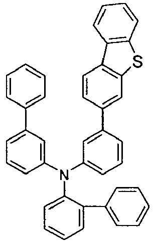 | 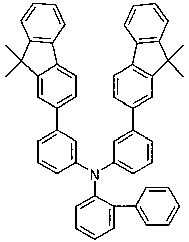 | 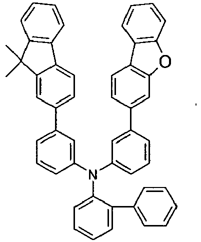 |
| 58 | 59 | 60 |
| 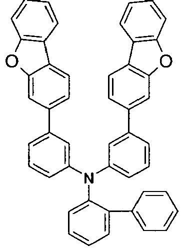 | 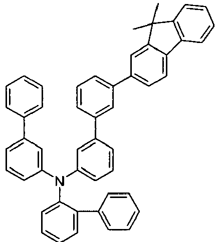 | 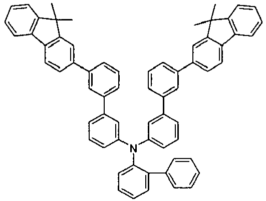 |
| 61 | 62 | 63 |
| 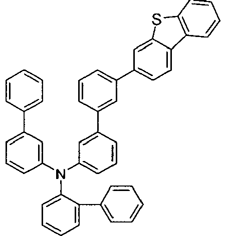 | 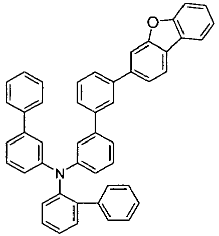 | 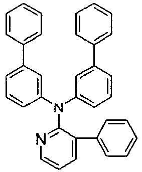 |
| 64 | 65 | 66 |
| 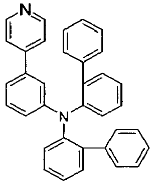 | 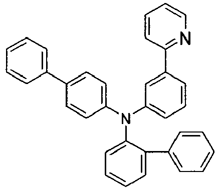 | 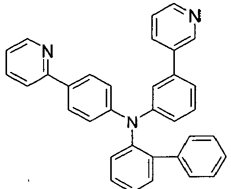 |
| 67 | 68 | 69 |
| 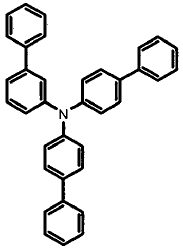 | 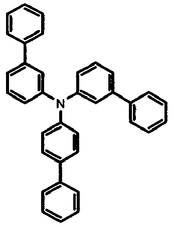 | 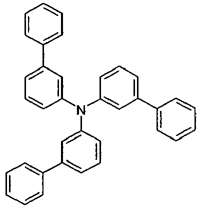 |
| 70 | 71 | 72 |
| 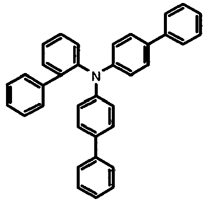 | 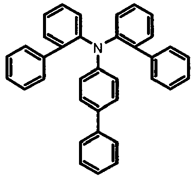 | 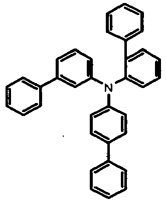 |
| 73 | 74 | 75 |
| 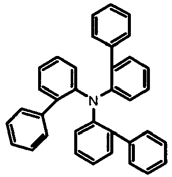 | 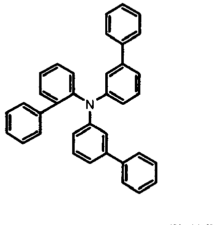 | 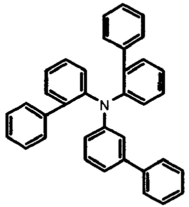 |
| 76 | 77 | 78 |
| 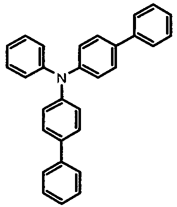 | 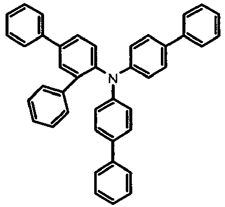 | 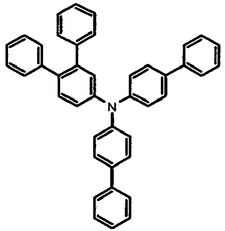 |
| 79 | 80 | 81 |
| 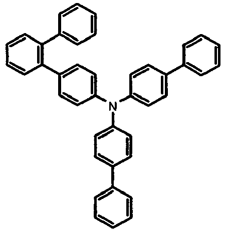 | 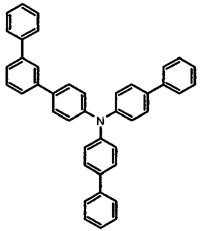 | 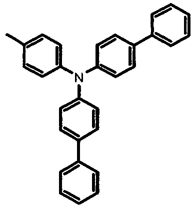 |
| 82 | 83 | 84 |
| 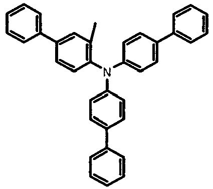 | 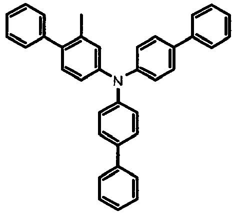 | 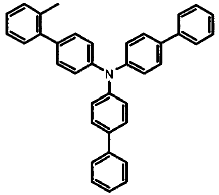 |
| 85 | 86 | 87 |
| 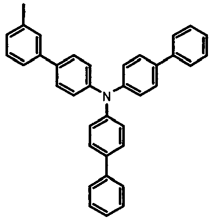 | 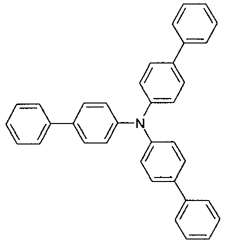 | 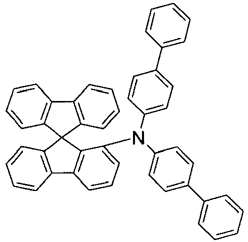 |
| 88 | 89 | 90 |
| 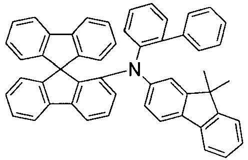 | 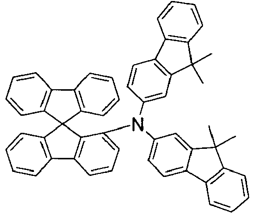 | 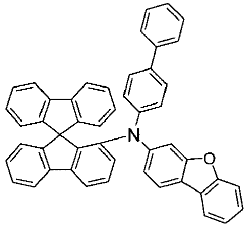 |
| 91 | 92 | 93 |
| 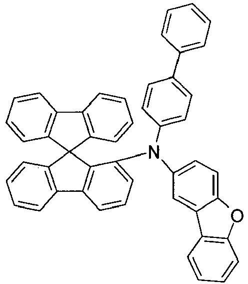 | 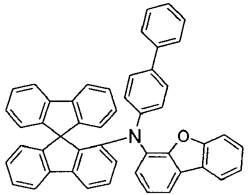 | 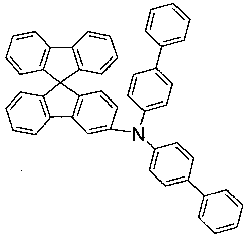 |
| 94 | 95 | 96 |
| 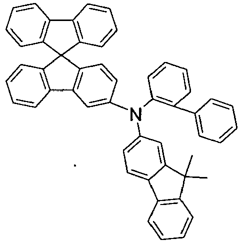 | 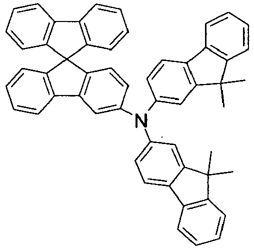 | 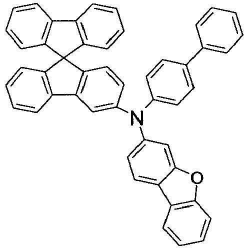 |
| 97 | 98 | 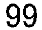 |
| 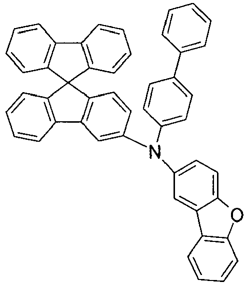 | 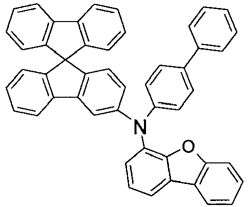 | 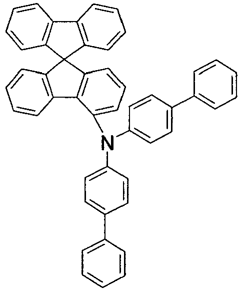 |
| 100 | 101 | 102 |
| 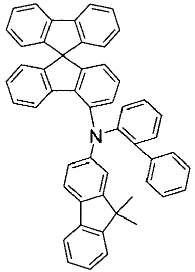 | 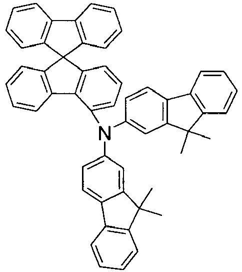 | 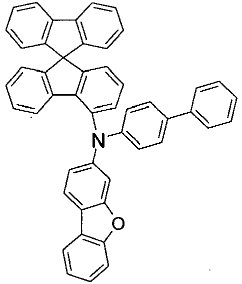 |
| 103 | 104 | 105 |
| 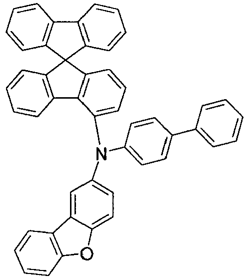 | 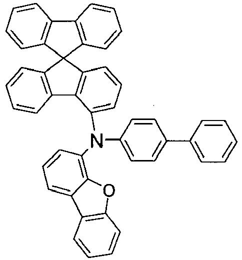 | 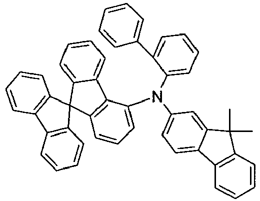 |
| 106 | 107 | 108 |
| 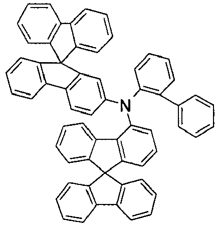 | 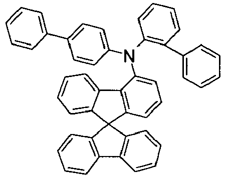 | 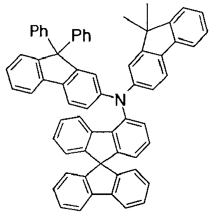 |
| 109 | 110 | 111 |
| 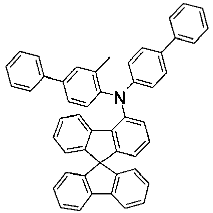 | 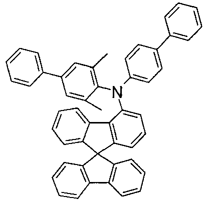 | 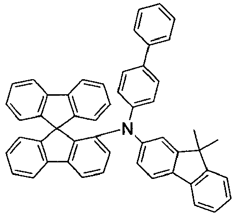 |
| 112 | 113 | 114 |
| 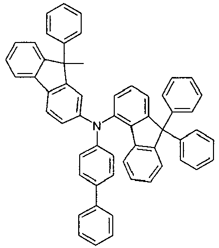 | 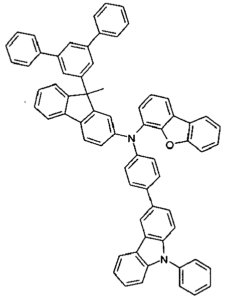 | 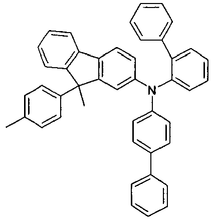 |
| 115 | 116 | 117 |
| 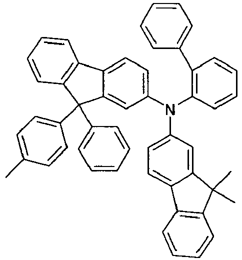 | 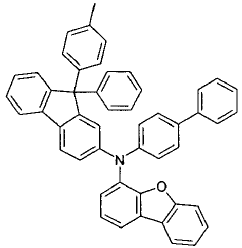 | 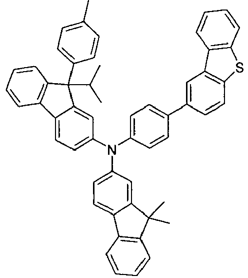 |
| 118 | 119 | 120 |
| 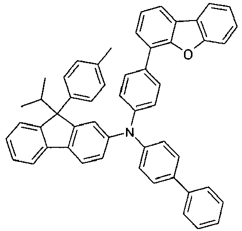 | 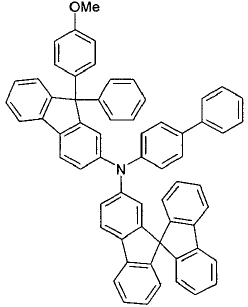 | 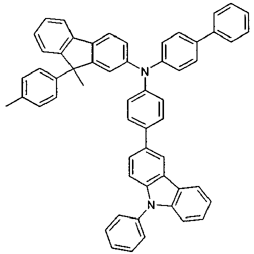 |
| 121 | 122 | 123 |
| 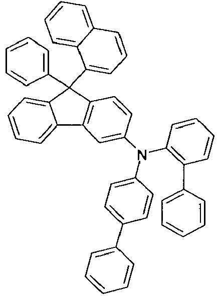 | 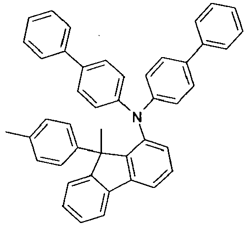 | 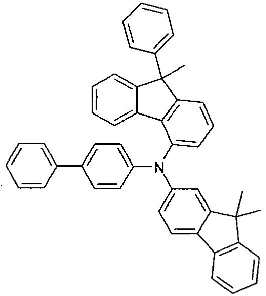 |
| 124 | 125 | 126 |
| 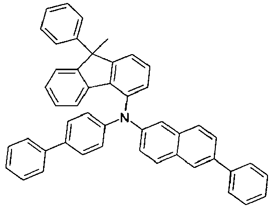 | 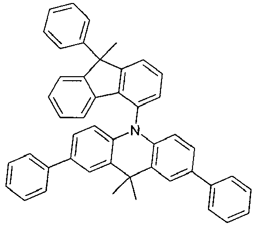 | 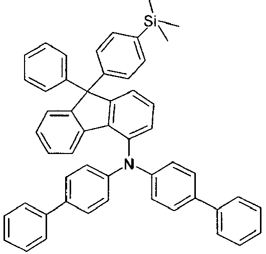 |
| 127 | 128 | 129 |
| 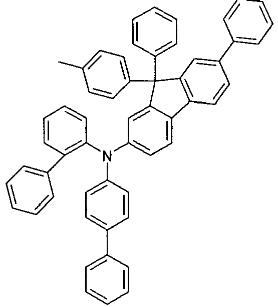 | 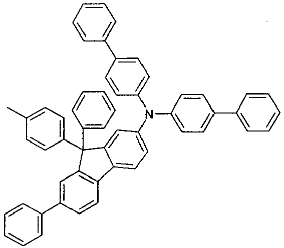 | 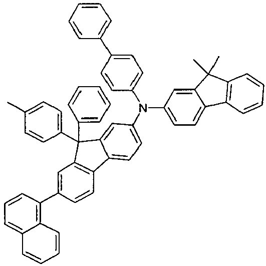 |
| 130 | 131 | 132 |
| 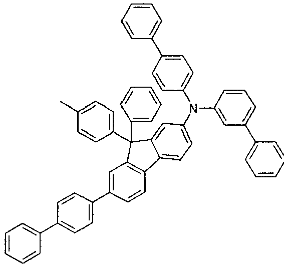 | 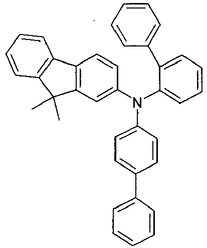 | 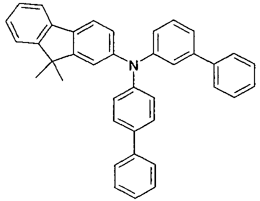 |
| 133 | 134 | 135 |
| 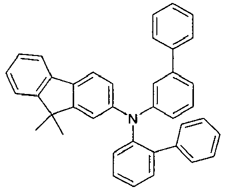 | 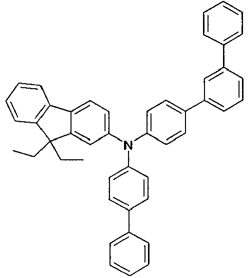 | 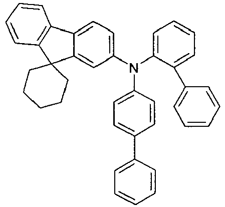 |
| 136 | 137 | 138 |
| 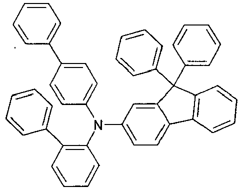 | 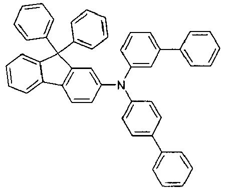 | 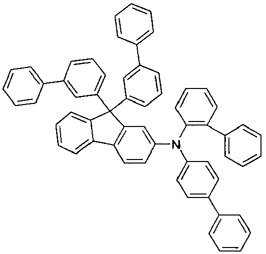 |
| 139 | 140 | 141 |
| 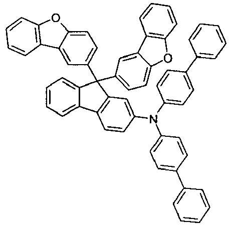 | 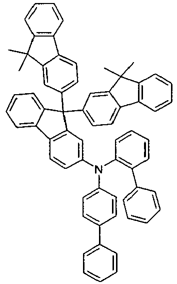 | 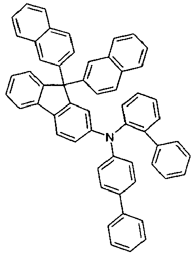 |
| 142 | 143 | 144 |
| 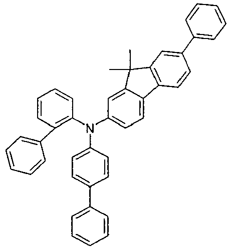 | 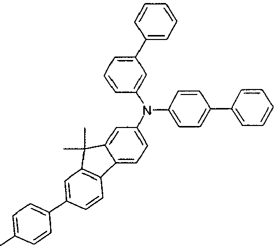 | 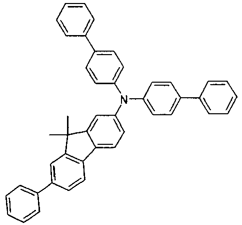 |
| 145 | 146 | 147 |
| 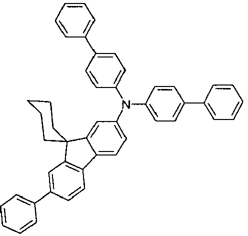 | 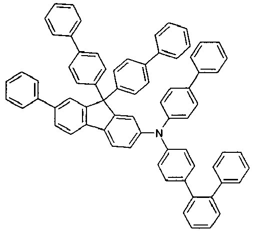 | 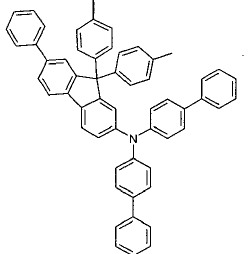 |
| 148 | 149 | 150 |
| 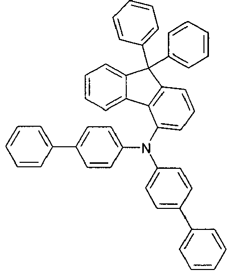 | 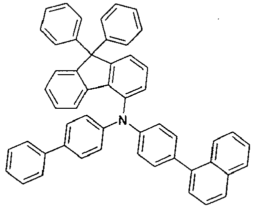 | 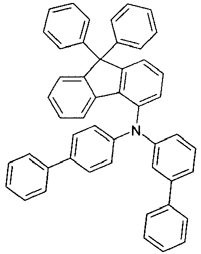 |
| 151 | 152 | 153 |
| 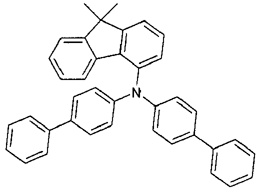 | 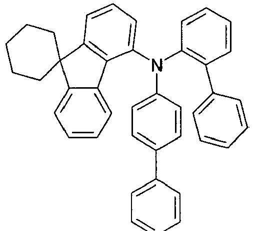 | 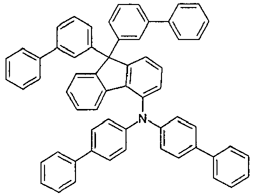 |
| 154 | 155 | 156 |
| 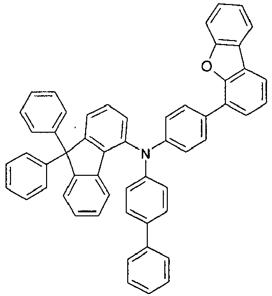 | 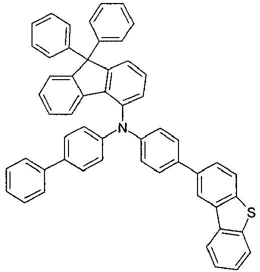 | 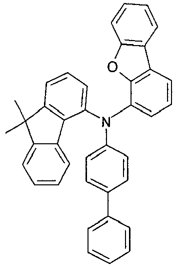 |
| 157 | 158 | 159 |
| 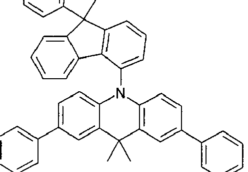 | 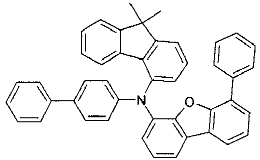 | 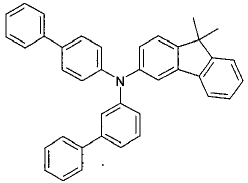 |
| 160 | 161 | 162 |
| 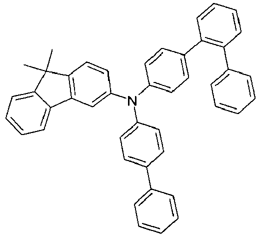 | 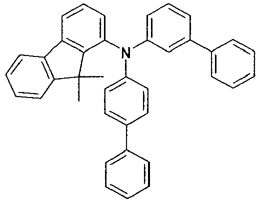 | 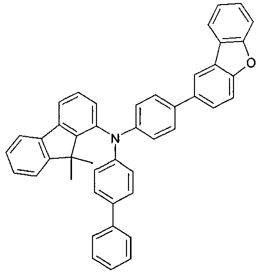 |
| 163 | 164 | 165 |
| 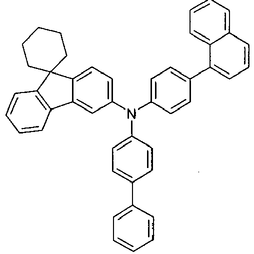 | 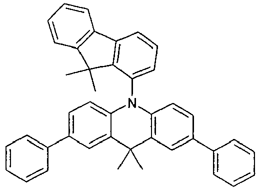 | 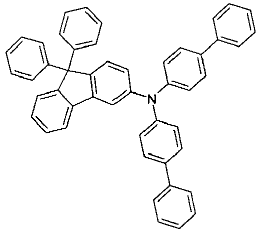 |
| 166 | 167 | 168 |
| 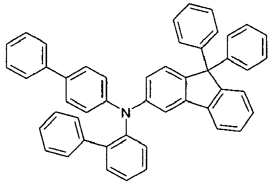 | 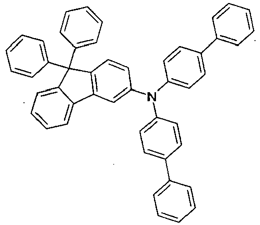 | 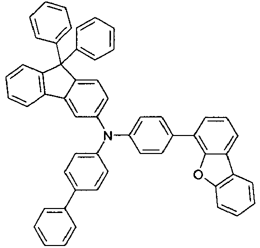 |
| 169 | 170 | 171 |
| 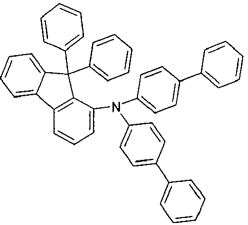 | 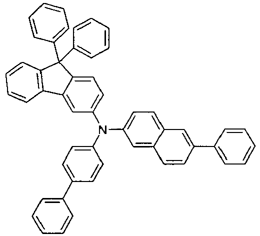 | 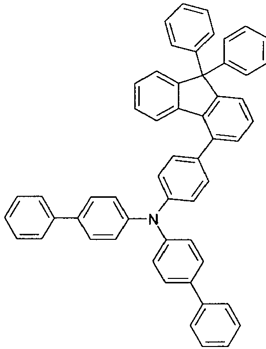 |
| 172 | 173 | 174 |
| 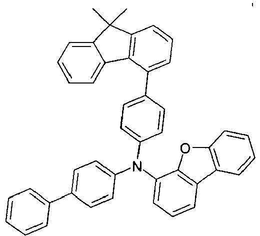 | 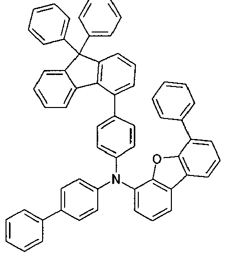 | 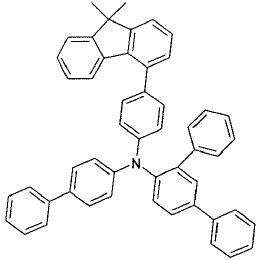 |
| 175 | 176 | 177 |
| 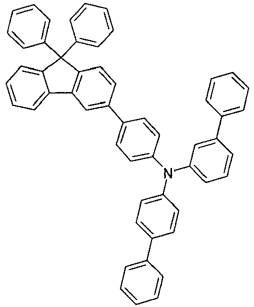 | 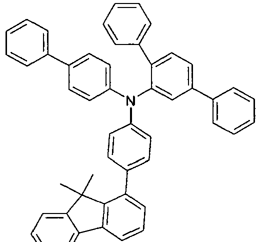 | 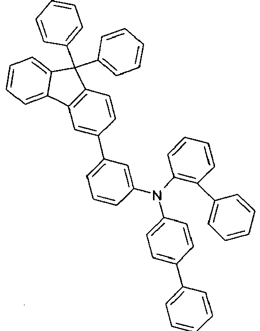 |
| 178 | 179 | 180 |
| 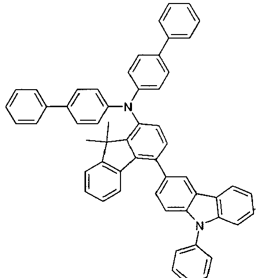 | 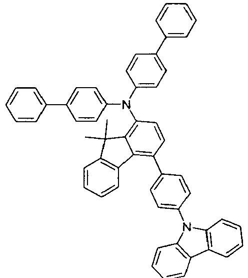 | 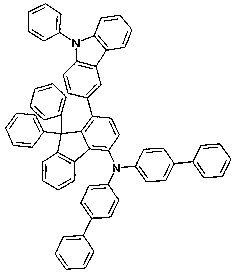 |
| 181 | 182 | 183 |
| 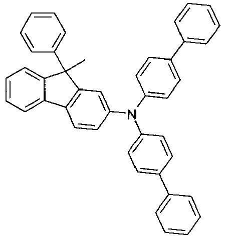 | | |
| 184 | | |

Es folgen allgemeine Definitionen für chemische Gruppen im Rahmen der vorliegenden Anmeldung:
Eine Arylgruppe im Sinne dieser Erfindung enthält 6 bis 60 aromatische Ringatome; eine Heteroarylgruppe im Sinne dieser Erfindung enthält 5 bis 60 aromatische Ringatome, von denen mindestens eines ein Heteroatom darstellt. Die Heteroatome sind bevorzugt ausgewählt aus N, O und S. Dies stellt die grundlegende Definition dar. Werden in der Beschreibung der vorliegenden Erfindung andere Bevorzugungen angegeben, beispielsweise bezüglich der Zahl der aromatischen Ringatome oder der enthaltenen Heteroatome, so gelten diese.

Dabei wird unter einer Arylgruppe bzw. Heteroarylgruppe entweder ein einfacher aromatischer Cyclus, also Benzol, bzw. ein einfacher heteroaromatischer Cyclus, beispielsweise Pyridin, Pyrimidin oder Thiophen, oder ein kondensierter (annellierter) aromatischer bzw. heteroaromatischer Polycyclus, beispielsweise Naphthalin, Phenanthren, Chinolin oder Carbazol verstanden. Ein kondensierter (annellierter) aromatischer bzw. heteroaromatischer Polycyclus besteht im Sinne der vorliegenden Anmeldung aus zwei oder mehr miteinander kondensierten einfachen aromatischen bzw. heteroaromatischen Cyclen.

Unter einer Aryl- oder Heteroarylgruppe, die jeweils mit den oben genannten Resten substituiert sein kann und die über beliebige Positionen am Aromaten bzw. Heteroaromaten verknüpft sein kann, werden insbesondere Gruppen verstanden, welche abgeleitet sind von Benzol, Naphthalin, Anthracen, Phenanthren, Pyren, Dihydropyren, Chrysen, Perylen, Fluoranthen, Benzanthracen, Benzphenanthren, Tetracen, Pentacen, Benzpyren, Furan, Benzofuran, Isobenzofuran, Dibenzofuran, Thiophen, Benzothiophen, Isobenzothiophen, Dibenzothiophen, Pyrrol, Indol, Isoindol, Carbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, Pyrazin, Phenazin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol.

Unter einer Aryloxygruppe gemäß der Definition der vorliegenden Erfindung wird eine Arylgruppe, wie oben definiert, verstanden, welche über ein Sauerstoffatom gebunden ist. Eine analoge Definition gilt für Heteroaryloxygruppen.

Ein aromatisches Ringsystem im Sinne dieser Erfindung enthält 6 bis 60 C-Atome im Ringsystem. Ein heteroaromatisches Ringsystem im Sinne dieser Erfindung enthält 5 bis 60 aromatische Ringatome, von denen mindestens eines ein Heteroatom darstellt. Die Heteroatome sind bevorzugt ausgewählt aus N, O und/oder S. Unter einem aromatischen oder heteroaromatischen Ringsystem im Sinne dieser Erfindung soll ein System verstanden werden, das nicht notwendigerweise nur Aryl- oder Heteroarylgruppen enthält, sondern in dem auch mehrere Aryl- oder Heteroarylgruppen durch eine nicht-aromatische Einheit (bevorzugt weniger als 10 % der von H verschiedenen Atome), wie z. B. ein sp³-hybridisiertes C-, Si-, N- oder O-Atom, ein sp²-hybridisiertes C- oder N-Atom oder ein sp-hybridisiertes C-Atom, verbunden sein können. So sollen beispielsweise auch Systeme wie 9,9'-Spirobifluoren, 9,9'-Diarylfluoren, Triarylamin, Diarylether, Stilben, etc. als aromatische Ringsysteme im Sinne dieser Erfindung verstanden werden, und ebenso Systeme, in denen zwei oder mehrere Arylgruppen beispielsweise durch eine lineare oder cyclische Alkyl-, Alkenyl- oder Alkinylgruppe oder durch eine Silylgruppe verbunden sind. Weiterhin werden auch Systeme, in denen zwei oder mehr Aryl- oder Heteroarylgruppen über Einfachbindungen miteinander verknüpft sind, als aromatische oder heteroaromatische Ringsysteme im Sinne dieser Erfindung verstanden, wie beispielsweise Systeme wie Biphenyl, Terphenyl oder Diphenyltriazin.

Unter einem aromatischen oder heteroaromatischen Ringsystem mit 5-60 aromatischen Ringatomen, welches noch jeweils mit Resten wie oben definiert substituiert sein kann und welches über beliebige Positionen am Aromaten bzw. Heteroaromaten verknüpft sein kann, werden insbesondere Gruppen verstanden, die abgeleitet sind von Benzol, Naphthalin, Anthracen, Benzanthracen, Phenanthren, Benzphenanthren, Pyren, Chrysen, Perylen, Fluoranthen, Naphthacen, Pentacen, Benzpyren, Biphenyl, Biphenylen, Terphenyl, Terphenylen, Quaterphenyl, Fluoren, Spirobifluoren, Dihydrophenanthren, Dihydropyren, Tetrahydropyren, cis- oder trans-Indenofluoren, Truxen, Isotruxen, Spirotruxen, Spiroisotruxen, Furan, Benzofuran, Isobenzofuran, Dibenzofuran, Thiophen, Benzothiophen, Isobenzothiophen, Dibenzothiophen, Pyrrol, Indol, Isoindol, Carbazol, Indolocarbazol, Indenocarbazol, Pyridin, Chinolin, Isochinolin, Acridin, Phenanthridin, Benzo-5,6-chinolin, Benzo-6,7-chinolin, Benzo-7,8-chinolin, Phenothiazin, Phenoxazin, Pyrazol, Indazol, Imidazol, Benzimidazol, Naphthimidazol, Phenanthrimidazol, Pyridimidazol, Pyrazinimidazol, Chinoxalinimidazol, Oxazol, Benzoxazol, Naphthoxazol, Anthroxazol, Phenanthroxazol, Isoxazol, 1,2-Thiazol, 1,3-Thiazol, Benzothiazol, Pyridazin, Benzopyridazin, Pyrimidin, Benzpyrimidin, Chinoxalin, 1,5-Diazaanthracen, 2,7-Diazapyren, 2,3-Diazapyren, 1,6-Diazapyren, 1,8-Diazapyren, 4,5-Diazapyren, 4,5,9,10-Tetraazaperylen, Pyrazin, Phenazin, Phenoxazin, Phenothiazin, Fluorubin, Naphthyridin, Azacarbazol, Benzocarbolin, Phenanthrolin, 1,2,3-Triazol, 1,2,4-Triazol, Benzotriazol, 1,2,3-Oxadiazol, 1,2,4-Oxadiazol, 1,2,5-Oxadiazol, 1,3,4-Oxadiazol, 1,2,3-Thiadiazol, 1,2,4-Thiadiazol, 1,2,5-Thiadiazol, 1,3,4-Thiadiazol, 1,3,5-Triazin, 1,2,4-Triazin, 1,2,3-Triazin, Tetrazol, 1,2,4,5-Tetrazin, 1,2,3,4-Tetrazin, 1,2,3,5-Tetrazin, Purin, Pteridin, Indolizin und Benzothiadiazol oder Kombinationen dieser Gruppen.

Im Rahmen der vorliegenden Erfindung werden unter einer geradkettigen Alkylgruppe mit 1 bis 40 C-Atomen bzw. einer verzweigten oder cyclischen Alkylgruppe mit 3 bis 40 C-Atomen bzw. einer Alkenyl- oder Alkinylgruppe mit 2 bis 40 C-Atomen, in der auch einzelne H-Atome oder CH₂-Gruppen durch die oben bei der Definition der Reste genannten Gruppen substituiert sein können, bevorzugt die Reste Methyl, Ethyl, n-Propyl, i-Propyl, n-Butyl, i-Butyl, s-Butyl, t-Butyl, 2-Methylbutyl, n-Pentyl, s-Pentyl, Cyclopentyl, neoPentyl, n-Hexyl, Cyclohexyl, neo-Hexyl, n-Heptyl, Cycloheptyl, n-Octyl, Cyclooctyl, 2-Ethylhexyl, Trifluormethyl, Pentafluorethyl, 2,2,2-Trifluorethyl, Ethenyl, Propenyl, Butenyl, Pentenyl, Cyclopentenyl, Hexenyl, Cyclohexenyl, Heptenyl, Cycloheptenyl, Octenyl, Cyclooctenyl, Ethinyl, Propinyl, Butinyl, Pentinyl, Hexinyl oder Octinyl verstanden. Unter einer Alkoxy- oder Thioalkylgruppe mit 1 bis 40 C-Atomen werden bevorzugt Methoxy, Trifluormethoxy, Ethoxy, n-Propoxy, i-Propoxy, n-Butoxy, i-Butoxy, s-Butoxy, t-Butoxy, n-Pentoxy, s-Pentoxy, 2-Methylbutoxy, n-Hexoxy, Cyclohexyloxy, n-Heptoxy, Cycloheptyloxy, n-Octyloxy, Cyclooctyloxy, 2-Ethylhexyloxy, Pentafluorethoxy, 2,2,2-Trifluorethoxy, Methylthio, Ethylthio, n-Propylthio, i-Propylthio, n-Butylthio, i-Butylthio, s-Butylthio, t-Butylthio, n-Pentylthio, s-Pentylthio, n-Hexylthio, Cyclohexylthio, n-Heptylthio, Cycloheptylthio, n-Octylthio, Cyclooctylthio, 2-Ethylhexylthio, Trifluormethylthio, Pentafluorethylthio, 2,2,2-Trifluorethylthio, Ethenylthio, Propenylthio, Butenylthio, Pentenylthio, Cyclopentenylthio, Hexenylthio, Cyclohexenylthio, Heptenylthio, Cycloheptenylthio, Octenylthio, Cyclooctenylthio, Ethinylthio, Propinylthio, Butinylthio, Pentinylthio, Hexinylthio, Heptinylthio oder Octinylthio verstanden.

Unter der Formulierung, dass zwei oder mehr Reste miteinander einen Ring bilden können, soll im Rahmen der vorliegenden Anmeldung unter anderem verstanden werden, dass die beiden Reste miteinander durch eine chemische Bindung verknüpft sind. Dies wird durch das folgende Schema verdeutlicht:

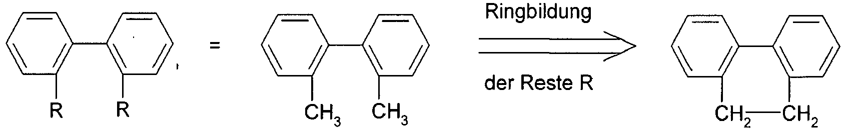

Weiterhin soll unter der oben genannten Formulierung aber auch verstanden werden, dass für den Fall, dass einer der beiden Reste Wasserstoff darstellt, der zweite Rest unter Bildung eines Rings an die Position, an die das Wasserstoffatom gebunden war, bindet. Dies soll durch das folgende Schema verdeutlicht werden:

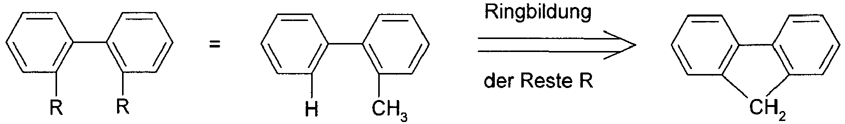

Das Matrixmaterial M2 ist bevorzugt eine Verbindung enthaltend mindestens eine Anthraceneinheit. Bevorzugt ist sie eine wahlweise mit R³ substituierte 9,10-Diarylanthracen-Verbindung.

Bevorzugt entspricht M2 der folgenden Formel (II) 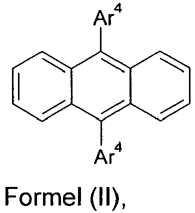 wobei gilt:
- Ar⁴: ist bei jedem Auftreten gleich oder verschieden ein aromatisches oder heteroaromatisches Ringsystem mit 5 bis 40 aromatischen Ringatomen, das mit einem oder mehreren Resten R³ substituiert sein kann; und
- R³: ist bei jedem Auftreten gleich oder verschieden H, D, F, C(=O)R⁴, CN, Si(R⁴)₃, N(R⁴)₂, P(=O)(R⁴)₂, S(=O)R⁴, S(=O)₂R⁴, eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten R⁴ substituiert sein können und wobei eine oder mehrere CH₂-Gruppen in den oben genannten Gruppen durch -R⁴C=CR⁴-, -C≡C-, Si(R⁴)₂, C=O, C=S, C=NR⁴, -C(=O)O-, -C(=O)NR⁴-, NR⁴, P(=O)(R⁴), -O-, -S-, SO oder SO₂ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste R⁴ substituiert sein kann, oder eine Aryloxy- oder Heteroaryloxygruppe mit 5 bis 30 aromatischen Ringatomen, die durch einen oder mehrere Reste R⁴ substituiert sein kann, wobei zwei oder mehr Reste R³ miteinander verknüpft sein können und einen Ring bilden können;
- R⁴: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R⁴ miteinander verknüpft sein und einen Ring bilden, und
das Anthracen kann an allen freien Positionen mit einer Gruppe R³ substituiert sein.

Ar⁴ ist bevorzugt bei jedem Auftreten gleich oder verschieden gewählt aus Arylgruppen mit 6 bis 18 aromatischen Ringatomen, bevorzugt 6 bis 14 aromatischen Ringatomen, die mit einem oder mehreren Resten R³ substituiert sein können.

Besonders bevorzugt entspricht M2 der Formel (II-1) 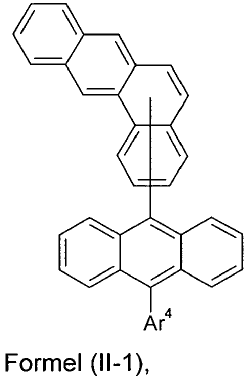 wobei Ar⁴ wie oben definiert ist und die Benzanthracenylgruppe in den Positionen 1, 2, 3, 4, 5 oder 6 an das Anthracen gebunden sein kann und das Benzanthracen und das Anthracen an allen freien Positionen mit einer Gruppe R³ substituiert sein kann.

Im Rahmen der Anmeldung wird folgende Nummerierung des Benzanthracen-Grundgerüsts verwendet:

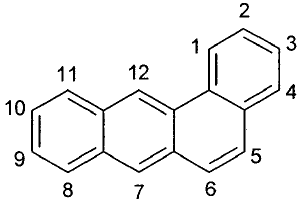

Weiterhin besonders bevorzugt entspricht M2 der folgenden Formel (II-2) 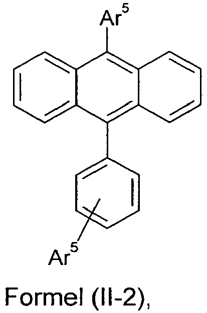 wobei
- Ar⁵: bei jedem Auftreten gleich oder verschieden gewählt ist aus einer kondensierten Aryl- oder Heteroarylgruppe mit 10 bis 18 aromatischen Ringatomen, die mit einem oder mehreren Resten R³ substituiert sein kann, und
die Anthracengruppe und die Phenylengruppe an allen freien Positionen mit einer Gruppe R³ substituiert sein kann.

Bevorzugt ist Ar⁵ gewählt aus Naphthyl-, Anthracenyl-, Pyrenyl- und Fluoranthenylgruppen, die mit einem oder mehreren Resten R³ substituiert sein können.

Besonders bevorzugt als Matrixmaterialien M2 sind die in WO 2006/097208, WO 2006/131192, WO 2007/065550, WO 2007/110129, WO 2007/065678, WO 2008/145239, WO 2009/100925, WO 2011/054442, und EP 1553154 offenbarten Anthracenderivate.

Das Matrixmaterial M2 ist weiterhin bevorzugt eine Verbindung enthaltend mindestens eine Pyreneinheit. Besonders bevorzugt ist M2 ein Pyrenderivat, das mit mindestens einem wahlweise substituierten aromatischen oder heteroaromatischen Ringsystem mit 6 bis 30 aromatischen Ringatomen substituiert ist. Ganz besonders bevorzugt ist M2 ein Pyrenderivat, das mit mindestens einem, bevorzugt mindestens zwei, aromatischen Ringsystemen mit 6 bis 24 aromatischen Ringatomen substituiert ist.

Bevorzugt ist M2 gewählt aus Verbindungen der Formel (III) 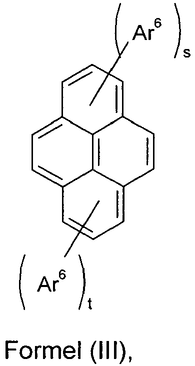 wobei gilt:
- Ar⁶: ist ein aromatisches oder heteroaromatisches Ringsystem mit 5 bis 40 aromatischen Ringatomen, das mit einem oder mehreren Resten R⁵ substituiert sein kann; und
- R⁵: ist bei jedem Auftreten gleich oder verschieden H, D, F, C(=O)R⁶, CN, Si(R⁶)₃, N(R⁶)₂, P(=O)(R⁶)₂, S(=O)R⁶, S(=O)₂R⁶, eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten R⁶ substituiert sein können und wobei eine oder mehrere CH₂-Gruppen in den oben genannten Gruppen durch -R⁶C=CR⁶-, -C≡C-, Si(R⁶)₂, C=O, C=S, C=NR⁶, -C(=O)O-, -C(=O)NR⁶-, NR⁶, P(=O)(R⁶), -O-, -S-, SO oder SO₂ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste R⁶ substituiert sein kann, oder eine Aryloxy- oder Heteroaryloxygruppe mit 5 bis 30 aromatischen Ringatomen, die durch einen oder mehrere Reste R⁶ substituiert sein kann, wobei zwei oder mehr Reste R⁵ miteinander verknüpft sein können und einen Ring bilden können;
- R⁶: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R⁶ miteinander verknüpft sein und einen Ring bilden; und
- s: ist 1, 2 oder 3;
- t: ist 0, 1, 2 oder 3;
wobei das Pyren an allen freien Positionen mit Resten R⁵ substituiert sein kann.

Besonders bevorzugt als Matrixmaterialien M2 sind die in EP 1749809, EP 1905754 und US 2012/0187826 offenbarten Pyren-Verbindungen.

Es ist weiterhin bevorzugt, dass der Dotand D eine fluoreszierende emittierende Verbindung ist.

Unter einer fluoreszierenden emittierenden Verbindung wird im Rahmen der vorliegenden Anmeldung eine Verbindung verstanden, welche Emission aus einem Übergang aus einem angeregten Singulett-Zustand heraus aufweist.

Bevorzugt ist der Dotand D ein kleines organisches Molekül mit einem Molekulargewicht von 200 bis 2000 Da, bevorzugt 250 bis 1500 Da und besonders bevorzugt 300 bis 1000 Da.

Bevorzugt ist der Dotand D keine polymere Verbindung.

Bevorzugt ist der Dotand D gewählt aus Verbindungen enthaltend mindestens eine substituierte oder unsubstituierte kondensierte Arylgruppe mit 10 bis 30 aromatischen Ringatomen. Bevorzugt trägt der Dotand mindestens eine Arylaminogruppe.

Bevorzugt ist der Dotand D eine Verbindung der folgenden Formel (IV-1) 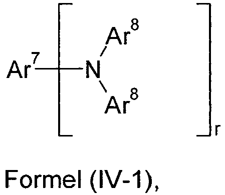 wobei gilt:
- Ar⁷: ist eine kondensierte Arylgruppe mit 10 bis 30 aromatischen Ringatomen, die mit einem oder mehreren Resten R⁷ substituiert sein kann;
- Ar⁸: ist ein aromatisches oder heteroaromatisches Ringsystem mit 6 bis 30 aromatischen Ringatomen, das mit einem oder mehreren Resten R⁷ substituiert sein kann;
- R⁷: ist bei jedem Auftreten gleich oder verschieden H, D, F, C(=O)R⁸, CN, Si(R⁸)₃, N(R⁸)₂, P(=O)(R⁸)₂, S(=O)R⁸, S(=O)₂R⁸, eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten R⁸ substituiert sein können und wobei eine oder mehrere CH₂-Gruppen in den oben genannten Gruppen durch -R⁸C=CR⁸-, -C≡C-, Si(R⁸)₂, C=O, C=S, C=NR⁸, -C(=O)O-, -C(=O)NR⁸-, NR⁸, P(=O)(R⁸), -O-, -S-, SO oder SO₂ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste R⁸ substituiert sein kann, oder eine Aryloxy- oder Heteroaryloxygruppe mit 5 bis 30 aromatischen Ringatomen, die durch einen oder mehrere Reste R⁸ substituiert sein kann, wobei zwei oder mehr Reste R⁷ miteinander verknüpft sein können und einen Ring bilden können;
- R⁸: ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R⁸ miteinander verknüpft sein und einen Ring bilden; und
- r: ist 1, 2, 3 oder 4.

Gemäß einer bevorzugten Ausführungsform ist r in Formel (IV) gleich 1 oder 2.

Bevorzugt ist Ar⁷ gewählt aus folgenden Gruppen:

| | |
|---|---|
| 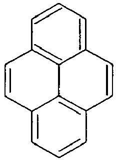 | 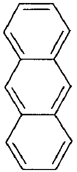 |
| Ar⁷-1 | Ar⁷-2 |
| | |
| 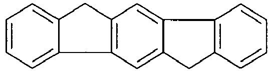 | 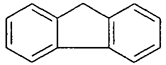 |
| Ar⁷-3 | Ar⁷-4 |
| 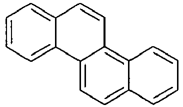 | 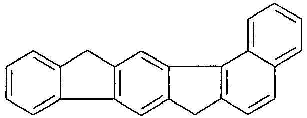 |
| Ar⁷-5 | Ar⁷-6 |
| | |
| 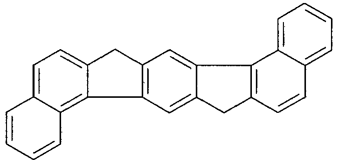 | |
| Ar⁷-7 | |

wobei die Gruppen an allen freien Positionen mit einem oder mehreren Resten R⁷ substituiert sein können, und
wobei die Gruppen der Formel Ar⁷-3 und Ar⁷-4 mindestens einen ankondensierten aromatischen Ring aufweisen müssen, der an einen der Sechsringe ankondensiert ist.

Ebenfalls bevorzugt entspricht der Dotand D der folgenden Formel (IV-2)

Ar⁹

Formel (IV-2), wobei gilt
- Ar⁹: ist gewählt aus kondensierten Arylgruppen mit 14 bis 30 aromatischen Ringatomen, die mit einem oder mehreren Resten R⁷ substituiert sein können, wobei R⁷ definiert ist wie oben.

Bevorzugt ist Ar⁹ gewählt aus kondensierten Arylgruppen mit 14 bis 20 aromatischen Ringatomen, die mit einem oder mehreren Resten R⁷ substituiert sein können.

Besonders bevorzugte Dotanden D sind die in WO 2006/108497 oder WO 2006/122630 offenbarten Indenofluorenamine bzw. -diamine, die in WO 2008/006449 offenbarten Benzoindenofluorenamine bzw. -diamine, die in WO 2007/140847 offenbarten Dibenzoindenofluorenamine bzw. -diamine, sowie die in WO 2010/012328 offenbarten Indenofluorenderivate mit kondensierten Arylgruppen. Ebenfalls besonders bevorzugt sind die in WO 2012/048780 und der noch nicht offengelegten EP 12004426.8 offenbarten Pyren-Arylamine. Ebenfalls bevorzugt sind die in der noch nicht offengelegten EP 12006239.3 offenbarten BenzoindenofluorenAmine.

Die emittierende Schicht der erfindungsgemäßen elektronischen Vorrichtung kann weitere Verbindungen enthalten. Bevorzugt sind solche weiteren Verbindungen in Anteilen von nicht mehr als 10 Vol.-% vorhanden, bevorzugt von nicht mehr als 5 Vol.-% und besonders bevorzugt von nicht mehr als 1 Vol.-%. Ganz besonders bevorzugt sind keine weiteren Verbindungen in der emittierenden Schicht enthalten.

Bevorzugt ist das Matrixmaterial M1 in der emittierenden Schicht in einem Anteil von 1 - 15 Vol.-%, besonders bevorzugt von 2 - 12 Vol.-%, ganz besonders bevorzugt von 3 - 10 Vol.-% und am stärksten bevorzugt von 7 - 10 Vol.-% vorhanden.

Bevorzugt ist das Matrixmaterial M2 in der emittierenden Schicht in einem Anteil von 70 bis 95 Vol.-%, besonders bevorzugt von 85 bis 90 Vol.-% vorhanden.

Bevorzugt ist der Dotand D in der emittierenden Schicht in einem Anteil von 0.5 - 10 Vol.-%, besonders bevorzugt 1 - 8 Vol.-% und ganz besonders bevorzugt 2 - 6 Vol.-% vorhanden.

Weiterhin bevorzugt emittiert die emittierende Schicht der erfindungsgemäßen elektronischen Vorrichtung Licht mit einem Emissionsmaximum bei einer Wellenlänge von 430 - 480 nm, bevorzugt 435 - 470 nm, besonders bevorzugt 440 - 460 nm.

Weiterhin bevorzugt emittiert die emittierende Schicht der erfindungsgemäßen elektronischen Vorrichtung Licht mit CIE-Koordinaten von x<0.25 und y<0.35, bevorzugt von x<0.2 und y<0.3. Weiterhin bevorzugt ist x>0.1 und y>0.

Weiterer Gegenstand der Erfindung ist eine Formulierung, enthaltend mindestens ein organisches Lösungsmittel, mindestens einen Dotanden D, mindestens ein Matrixmaterial M1 und mindestens ein Matrixmaterial M2, wobei D, M1 und M2 unterschiedlich gewählt sind und wobei M1 gewählt ist aus Mono-Triarylaminen und M2 gewählt ist aus Verbindungen enthaltend mindestens eine Anthraceneinheit oder aus Verbindungen enthaltend mindestens eine Pyreneinheit, und wobei M1 keine kondensierte Arylgruppe mit mehr als 10 aromatischen Ringatomen enthält.

Die Formulierung kann in einem Verfahren zur Herstellung einer elektronischen Vorrichtung verwendet werden. Insbesondere eignet sie sich zur Herstellung der emittierenden Schicht einer elektronischen Vorrichtung, bevorzugt einer OLED, durch Spin-Coating oder durch Druckverfahren. Wie solche Lösungen hergestellt werden können, ist dem Fachmann bekannt und beispielsweise in WO 2002/072714, WO 2003/019694 und der darin zitierten Literatur beschrieben.

Formulierungen können beispielsweise Lösungen, Dispersionen oder Emulsionen sein. Es kann bevorzugt sein, hierfür Mischungen aus zwei oder mehr Lösemitteln zu verwenden. Geeignete und bevorzugte Lösemittel sind beispielsweise Toluol, Anisol, o-, m- oder p-Xylol, Methylbenzoat, Mesitylen, Tetralin, Veratrol, THF, Methyl-THF, THP, Chlorbenzol, Dioxan, Phenoxytoluol, insbesondere 3-Phenoxytoluol, (-)-Fenchon, 1,2,3,5-Tetramethylbenzol, 1,2,4,5-Tetramethylbenzol, 1-Methylnaphthalin, 2-Methylbenzothiazol, 2-Phenoxyethanol, 2-Pyrrolidinon, 3-Methylanisol, 4-Methylanisol, 3,4-Dimethylanisol, 3,5-Dimethylanisol, Acetophenon, α-Terpineol, Benzothiazol, Butylbenzoat, Cumol, Cyclohexanol, Cyclohexanon, Cyclohexylbenzol, Decalin, Dodecylbenzol, Ethylbenzoat, Indan, Methylbenzoat, NMP, p-Cymol, Phenetol, 1,4-Diisopropylbenzol, Dibenzylether, Diethylenglycolbutylmethylether, Triethylenglycolbutylmethyl-ether, Diethylenglycoldibutylether, Triethylenglycoldimethylether, Diethylenglycolmonobutylether, Tripropylenglycoldimethylether, Tetraethylenglycoldimethylether, 2-Isopropylnaphthalin, Pentylbenzol, Hexylbenzol, Heptylbenzol, Octylbenzol, 1,1-Bis(3,4-Dimethylphenyl)ethan oder Mischungen dieser Lösemittel.

Für die erfindungsgemäße Formulierung gelten die oben angegebenen Bevorzugungen betreffend die Anteile der Verbindungen M1, M2 und D.

Weiterhin gelten für die erfindungsgemäße Formulierung die oben angegebenen bevorzugten Ausführungsformen für die Verbindungen M1, M2 und D.

Die erfindungsgemäße elektronische Vorrichtung ist bevorzugt gewählt aus organischen integrierten Schaltungen (OICs), organischen Feld-Effekt-Transistoren (OFETs), organischen Dünnfilmtransistoren (OTFTs), organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und organischen Elektrolumineszenzvorrichtungen (OLEDs).

Die erfindungsgemäße Vorrichtung kann außer Kathode, Anode und der emittierenden Schicht noch weitere Schichten enthalten. Diese sind beispielsweise gewählt aus jeweils einer oder mehreren Lochinjektionsschichten, Lochtransportschichten, Lochblockierschichten, Elektronentransportschichten, Elektroneninjektionsschichten, Elektronenblockierschichten, Excitonenblockierschichten, Zwischenschichten (Interlayers), Ladungserzeugungsschichten (Charge-Generation Layers) (IDMC 2003, Taiwan; Session 21 OLED (5), T. Matsumoto, T. Nakada, J. Endo, K. Mori, N. Kawamura, A. Yokoi, J. Kido, Multiphoton Organic EL Device Having Charge Generation Layer) und/oder organischen oder anorganischen p/n-Übergängen. Es sei aber darauf hingewiesen, dass nicht notwendigerweise jede dieser Schichten vorhanden sein muss.

Die Abfolge der Schichten der elektronischen Vorrichtung ist bevorzugt die folgende:
Anode-Lochinjektionsschicht-Lochtransportschicht-emittierende Schicht-Elektronentransportschicht-Elektroneninjektionsschicht-Kathode.

Dabei soll erneut darauf hingewiesen werden, dass nicht alle der genannten Schichten vorhanden sein müssen, und/oder dass zusätzlich weitere Schichten vorhanden sein können.

Die erfindungsgemäße Vorrichtung kann blaues oder weißes oder andersfarbiges Licht emittieren, auch wenn ihre emittierende Schicht blaues Licht emittiert. Dies kann dadurch erreicht werden, dass weitere emittierende Schichten und/oder Schichten vorhanden sind, die die Farbe des emittierten Lichts umwandeln.

Die erfindungsgemäße Vorrichtung kann eine oder mehrere weitere emittierende Schichten enthalten. Besonders bevorzugt weisen die emittierenden Schichten in diesem Fall insgesamt mehrere Emissionsmaxima zwischen 380 nm und 750 nm auf, so dass insgesamt weiße Emission resultiert, d. h. in den emittierenden Schichten werden verschiedene emittierende Verbindungen verwendet, die fluoreszieren oder phosphoreszieren können und die blaues oder gelbes oder orangefarbenes oder rotes Licht emittieren. Bevorzugt sind Dreischichtsysteme, also Systeme mit drei emittierenden Schichten, wobei die drei Schichten blaue, grüne und orange oder rote Emission zeigen, oder Zweischichtsysteme, wobei die zwei Schichten blaue und orange Emission zeigen (für den prinzipiellen Aufbau siehe z. B. WO 2005/011013). Gemäß einer bevorzugten Ausführungsform ist die blau emittierende Schicht eine fluoreszierende Schicht und die rot, orange, grün oder gelb emittierende(n) Schicht(en) sind phosphoreszierend.

Unter Fluoreszenz wird im Rahmen der vorliegenden Anmeldung Emission aus einem Übergang aus einem angeregten Singulett-Zustand verstanden. Unter Phosphoreszenz wird Emission aus einem spin-verbotenen Übergang verstanden, beispielsweise einem Übergang aus einem angeregten Triplettzustand oder einem Zustand mit einer höheren Spinquantenzahl, beispielsweise einem Quintett-Zustand.

Unter einer fluoreszierenden Schicht wird dabei eine Schicht enthaltend einen fluoreszierenden Emitter verstanden. Entsprechend wird unter einer phosphoreszierenden Schicht eine Schicht enthaltend einen phosphoreszierenden Emitter verstanden.

Als phosphoreszierende Emitter eignen sich insbesondere Verbindungen, die bei geeigneter Anregung Licht, vorzugsweise im sichtbaren Bereich, emittieren und außerdem mindestens ein Atom der Ordnungszahl größer 20, bevorzugt größer 38 und kleiner 84, besonders bevorzugt größer 56 und kleiner 80 enthalten. Bevorzugt werden als phosphoreszierende Dotanden Verbindungen, die Kupfer, Molybdän, Wolfram, Rhenium, Ruthenium, Osmium, Rhodium, Iridium, Palladium, Platin, Silber, Gold oder Europium enthalten, verwendet, insbesondere Verbindungen, die Iridium, Platin oder Kupfer enthalten.

Dabei werden im Sinne der vorliegenden Erfindung alle lumineszierenden Iridium-, Platin- oder Kupferkomplexe als phosphoreszierende Verbindungen angesehen. Beispiele der oben beschriebenen phosphoreszierenden Emitter können den Anmeldungen WO 2000/70655, WO 2001/41512, WO 2002/02714, WO 2002/15645, EP 1191613, EP 1191612, EP 1191614, WO 2005/033244, WO 2005/019373 und US 2005/0258742 entnommen werden.

Beispiele für fluoreszierende Emitter die oben als bevorzugte Ausführungsformen des Dotanden D angegebenen Verbindungen.

Geeignete Ladungstransportmaterialien, wie sie in der Lochinjektions- bzw. Lochtransportschicht bzw. Elektronenblockierschicht oder in der Elektronentransportschicht der erfindungsgemäßen organischen Elektrolumineszenzvorrichtung verwendet werden können, sind beispielsweise die in Y. Shirota et al., Chem. Rev. 2007, 107(4), 953-1010 offenbarten Verbindungen oder andere Materialien, wie sie gemäß dem Stand der Technik in diesen Schichten eingesetzt werden.

Als Materialien für die Elektronentransportschicht können alle Materialien verwendet werden, wie sie gemäß dem Stand der Technik als Elektronentransportmaterialien in der Elektronentransportschicht verwendet werden. Insbesondere eignen sich Aluminiumkomplexe, beispielsweise Alq₃, Zirkoniumkomplexe, beispielsweise Zrq₄, Benzimidazolderviate, Triazinderivate, Pyrimidinderivate, Pyridinderivate, Pyrazinderivate, Chinoxalinderivate, Chinolinderivate, Oxadiazolderivate, aromatische Ketone, Lactame, Borane, Diazaphospholderivate und Phosphinoxidderivate. Weiterhin geeignete Materialien sind Derivate der oben genannten Verbindungen, wie sie in JP 2000/053957, WO 2003/060956, WO 2004/028217, WO 2004/080975 und WO 2010/072300 offenbart werden.

Bevorzugt sind als Lochtransportmaterialien, die in einer Lochtransport-, Lochinjektions- oder Elektronenblockierschicht in der erfindungsgemäßen Elektrolumineszenzvorrichtung verwendet werden können, Indenofluorenamin-Derivate (z. B. gemäß WO 06/122630 oder WO 06/100896), die in EP 1661888 offenbarten Aminderivate, Hexaazatriphenylenderivate (z. B. gemäß WO 01/049806), Aminderivate mit kondensierten Aromaten (z. B. gemäß US 5,061,569), die in WO 95/09147 offenbarten Aminderivate, Monobenzoindenofluorenamine (z. B. gemäß WO 08/006449), Dibenzoindenofluorenamine (z. B. gemäß WO 07/140847), Spirobifluoren-Amine (z. B. gemäß WO 2012/034627 oder WO 2013/120577), Fluoren-Amine (z. B. gemäß den noch nicht offengelegten Anmeldungen EP 12005369.9, EP 12005370.7 und EP 12005371.5), Spiro-Dibenzopyran-Amine (z. B. gemäß WO 2013/083216) und Dihydroacridin-Derivate (z. B. gemäß WO 2012/150001).

Es ist erfindungsgemäß bevorzugt, dass in der erfindungsgemäßen Vorrichtung eine Lochtransportschicht vorhanden ist, die anodenseitig von der emittierenden Schicht angeordnet ist, und in der eine oder mehrere Mono-Triarylamin-Verbindungen vorhanden sind, wie oben definiert. Hierfür gelten dieselben Bevorzugungen wie für die Mono-TriarylaminVerbindung M1 der emittierenden Schicht.

Als Kathode der organischen Elektrolumineszenzvorrichtung sind Metalle mit geringer Austrittsarbeit, Metalllegierungen oder mehrlagige Strukturen aus verschiedenen Metallen bevorzugt, wie beispielsweise Erdalkalimetalle, Alkalimetalle, Hauptgruppenmetalle oder Lanthanoide (z. B. Ca, Ba, Mg, AI, In, Mg, Yb, Sm, etc.). Weiterhin eignen sich Legierungen aus einem Alkali- oder Erdalkalimetall und Silber, beispielsweise eine Legierung aus Magnesium und Silber. Bei mehrlagigen Strukturen können auch zusätzlich zu den genannten Metallen weitere Metalle verwendet werden, die eine relativ hohe Austrittsarbeit aufweisen, wie z. B. Ag oder AI, wobei dann in der Regel Kombinationen der Metalle, wie beispielsweise Ca/Ag, Mg/Ag oder Ba/Ag verwendet werden. Es kann auch bevorzugt sein, zwischen einer metallischen Kathode und dem organischen Halbleiter eine dünne Zwischenschicht eines Materials mit einer hohen Dielektrizitätskonstante einzubringen. Hierfür kommen beispielsweise Alkalimetall- oder Erdalkalimetallfluoride, aber auch die entsprechenden Oxide oder Carbonate in Frage (z. B. LiF, Li₂O, BaF₂, MgO, NaF, CsF, Cs₂CO₃, etc.). Weiterhin kann dafür Lithiumchinolinat (LiQ) verwendet werden. Die Schichtdicke dieser Schicht beträgt bevorzugt zwischen 0.5 und 5 nm.

Als Anode sind Materialien mit hoher Austrittsarbeit bevorzugt. Bevorzugt weist die Anode eine Austrittsarbeit größer 4.5 eV vs. Vakuum auf. Hierfür sind einerseits Metalle mit hohem Redoxpotential geeignet, wie beispielsweise Ag, Pt oder Au. Es können andererseits auch Metall/Metalloxid-Elektroden (z. B. Al/Ni/NiOₓ, Al/PtOₓ) bevorzugt sein. Für einige Anwendungen muss mindestens eine der Elektroden transparent oder teiltransparent sein, um entweder die Bestrahlung des organischen Materials (organische Solarzelle) oder die Auskopplung von Licht (OLED, O-LASER) zu ermöglichen. Bevorzugte Anodenmaterialien sind hier leitfähige gemischte Metalloxide. Besonders bevorzugt sind Indium-ZinnOxid (ITO) oder Indium-Zink Oxid (IZO). Bevorzugt sind weiterhin leitfähige, dotierte organische Materialien, insbesondere leitfähige dotierte Polymere. Weiterhin kann die Anode auch aus mehreren Schichten bestehen, beispielsweise aus einer inneren Schicht aus ITO und einer äußeren Schicht aus einem Metalloxid, bevorzugt Wolframoxid, Molybdänoxid oder Vanadiumoxid.

Die erfindungsgemäße Vorrichtung wird entsprechend (je nach Anwendung) strukturiert, kontaktiert und schließlich versiegelt, da sich die Lebensdauer der erfindungsgemäßen Vorrichtungen bei Anwesenheit von Wasser und/oder Luft verkürzt.

In einer bevorzugten Ausführungsform ist die erfindungsgemäße Vorrichtung dadurch gekennzeichnet, dass eine oder mehrere Schichten mit einem Sublimationsverfahren beschichtet werden. Dabei werden die Materialien in Vakuum-Sublimationsanlagen bei einem Anfangsdruck kleiner 10⁻⁵ mbar, bevorzugt kleiner 10⁻⁶ mbar aufgedampft. Dabei ist es jedoch auch möglich, dass der Anfangsdruck noch geringer ist, beispielsweise kleiner 10⁻⁷ mbar.

Bevorzugt ist ebenfalls, dass eine oder mehrere Schichten mit dem OVPD (Organic Vapour Phase Deposition) Verfahren oder mit Hilfe einer Trägergassublimation beschichtet werden. Dabei werden die Materialien bei einem Druck zwischen 10⁻⁵ mbar und 1 bar aufgebracht. Ein Spezialfall dieses Verfahrens ist das OVJP (Organic Vapour Jet Printing) Verfahren, bei dem die Materialien direkt durch eine Düse aufgebracht und so strukturiert werden (z. B. M. S. Arnold et al., Appl. Phys. Lett. 2008, 92, 053301).

Weiterhin bevorzugt ist, dass eine oder mehrere Schichten aus Lösung, wie z. B. durch Spincoating, oder mit einem beliebigen Druckverfahren, wie z. B. Siebdruck, Flexodruck, Nozzle Printing oder Offsetdruck, besonders bevorzugt aber LITI (Light Induced Thermal Imaging, Thermotransferdruck) oder Ink-Jet Druck (Tintenstrahldruck), hergestellt werden. Insbesondere ist es bevorzugt, dass die emittierende Schicht der erfindungsgemäßen Vorrichtung aus Lösung aufgetragen wird. Hierfür wird bevorzugt eine der oben angegebenen bevorzugten Formulierungen verwendet.

Weiterhin bevorzugt ist es, dass zur Herstellung einer erfindungsgemäßen organischen Elektrolumineszenzvorrichtung eine oder mehrere Schichten aus Lösung und eine oder mehrere Schichten durch ein Sublimationsverfahren aufgetragen werden.

Erfindungsgemäß können die elektronischen Vorrichtungen enthaltend eine oder mehrere Verbindungen gemäß Formel (I) in Displays, als Lichtquellen in Beleuchtungsanwendungen sowie als Lichtquellen in medizinischen und/oder kosmetischen Anwendungen (z.B. Lichttherapie) eingesetzt werden.

### Ausführungsbeispiele

### A) Herstellung der OLEDs

In den folgenden Beispielen V1 bis V7 und E1 bis E7 (siehe Tabelle 1 für Aufbau der Vorrichtung und Tabelle 2 für Daten der Vorrichtung) werden die Ergebnisse verschiedener OLEDs vorgestellt. E bezeichnet erfindungsgemäße Beispiele, V bezeichnet Vergleichsbeispiele.

Glasplättchen, die mit strukturiertem ITO (Indium Zinn Oxid) der Dicke 50 nm beschichtet sind, werden nass gereinigt (Spülmaschine, Reiniger Merck Extran). Für die HTL-Schichtenanordnungen B und C (s. unten) werden diese Glasplättchen mit einem UV-Ozon Plasma behandelt und zur verbesserten Prozessierung eine 20 nm PEDOT:PSS Schicht aufgebracht (Poly(3,4-ethylendioxythiophen) poly(styrensulfonat), bezogen als CLEVIOS™ P VP AI 4083 von Heraeus Clevios Deutschland, aus wässriger Lösung aufgeschleudert). Für die HTL-Schichtenanordnung A werden die Glasplättchen vor dem Aufdampfen der organischen Schichten 15 min lang bei 250°C ausgeheizt und anschließend mit einem Sauerstoffplasma behandelt.

Die Glasplättchen bilden die Substrate, auf welche die OLEDs aufgebracht werden. Die OLEDs haben prinzipiell folgenden Schichtaufbau: Substrat / HTL-Schichtenanordnung / Emissionsschicht (EML) / Elektronentransportschicht (ETL) / Optionale Elektroneninjektionsschicht (EIL) und abschließend eine Kathode. Die Kathode wird durch eine 100 nm dicke Aluminiumschicht gebildet. Der genaue Aufbau der OLEDs ist Tabelle 1 zu entnehmen. Die zur Herstellung der OLEDs benötigten Materialien sind in Tabelle 3 gezeigt.

Die HTL-Schichtenanordnung A besteht vom Substrat aus gesehen aus einer 90 nm dicken Schicht des Materials SpA2, 10 nm HATCN, 30 nm SpA2, 10 nm HATCN und 20 nm MA1.

Die HTL-Schichtenanordnung B besteht analog aus 140 nm SpA1, 5 nm HATCN und 20 nm CbzA1.

Die HTL-Schichtenanordnung C besteht analog aus 140 nm SpA1, 5 nm HATCN und 20 nm MA1.

Alle Materialien werden in einer Vakuumkammer thermisch aufgedampft. Dabei besteht die Emissionsschicht immer aus mindestens einem Matrixmaterial (Hostmaterial, Wirtsmaterial) und einem emittierenden Dotierstoff (Dotand, Emitter), der dem Matrixmaterial bzw. den Matrixmaterialien durch Coverdampfung in einem bestimmten Volumenanteil beigemischt wird. Eine Angabe wie M1:CbzA1:D1 (89%:8%:3%) bedeutet hierbei, dass das Material M1 in einem Volumenanteil von 89%, CbzA1 in einem Anteil von 8% und D1 in einem Anteil von 3% in der Schicht vorliegt.

Die OLEDs werden standardmäßig charakterisiert. Hierfür werden die Elektrolumineszenzspektren, die Stromeffizienz (gemessen in cd/A), die Leistungseffizienz (gemessen in Im/W) und die externe Quanteneffizienz (EQE, gemessen in Prozent) in Abhängigkeit der Leuchtdichte, berechnet aus Strom-Spannungs-Leuchtdichte-Kennlinien (IUL-Kennlinien) unter Annahme einer lambertschen Abstrahlcharakteristik sowie die Lebensdauer bestimmt. Die Elektrolumineszenzspektren werden bei einer Leuchtdichte von 1000 cd/m² bestimmt und daraus die CIE 1931 x und y Farbkoordinaten berechnet. Die Angabe U1000 in Tabelle 2 bezeichnet die Spannung, die für eine Leuchtdichte von 1000 cd/m² benötigt wird. SE1000 und LE1000 bezeichnen die Strom- bzw. Leistungseffizienz, die bei 1000 cd/m² erreicht werden. EQE1000 schließlich bezeichnet die externe Quanteneffizienz bei einer Betriebsleuchtdichte von 1000 cd/m². Als Lebensdauer LD wird die Zeit definiert, nach der die Leuchtdichte bei Betrieb mit konstantem Strom von der Startleuchtdichte L0 auf einen gewissen Anteil L1 absinkt. Eine Angabe von L0 = 6000 cd/m² und L1 = 70% in Tabelle 2 bedeutet, dass die in Spalte LD angegebene Lebensdauer der Zeit entspricht, nach der die Anfangsleuchtdichte von 6000 cd/m² auf 4200 cd/m² absinkt.

Die Daten der verschiedenen OLEDs sind in Tabelle 2 zusammengefasst. Die Beispiel V1-V7 sind Vergleichsbeispiele gemäß dem Stand der Technik, die Beispiele E1-E7 zeigen Daten von OLEDs mit erfindungsgemäßem Aufbau.

Wie man der Tabelle entnehmen kann, erhält man mit Triaryl-Monoaminen (Verbindungen MA1 und MA2) als zusätzliche Komponente in der Emissionsschicht deutlich bessere Werte für Spannung, vor allem aber auch Effizienz und Lebensdauer im Vergleich zu Aminverbindungen mit zwei oder mehr Arylamingruppen (Verbindungen CbzA1, SpA1, NPB).

Dieser Effekt wird mit unterschiedlichen Dotanden erreicht, wie die Beispiele mit verschiedenen Dotanden zeigen (aminfreier Pyren-Emitter, Monobenzoindenofluoren-Amin D2, Perylenderivat TBP).

**Tabelle 1: Aufbau der OLEDs**

| Bsp. | HTL-Stack | EML Dicke | ETL Dicke | EIL Dicke |
|---|---|---|---|---|
| V1 | A | M1:CbzA1:D1 (89%:8%:3%) 20nm | ST1:LiQ (50%:50%) 30nm | --- |
| V2 | B | M1:CbzA1:D2 (90%:5%:5%) 30nm | ST1:LiQ (50%:50%) 20nm | LiQ 1nm |
| V3 | B | M1:SpA1:D2 (90%:5%:5%) 30nm | ST1:LiQ (50%:50%) 20nm | LiQ 1nm |
| V4 | C | M1:CbzA1:D2 (90%:5%:5%) 30nm | ST1:LiQ (50%:50%) 20nm | LiQ 1nm |
| V5 | C | M1:SpA1:D2 (90%:5%:5%) 30nm | ST1:LiQ (50%:50%) 20nm | LiQ 1nm |
| V6 | C | M1:NPB:D2 (90%:5%:5%) 30nm | ST1:LiQ (50%:50%) 20nm | LiQ 1nm |
| V7 | C | M1:NPB:TBP (91%:7%:2%) 30nm | ST1:LiQ (50%:50%) 20nm | LiQ 1nm |
| E1 | A | M1:MA1:D1 (89%:8%:3%) 20nm | ST1:LiQ (50%:50%) 30nm | --- |
| E2 | B | M1:MA1:D2 (90%:5%:5%) 30nm | ST1:LiQ (50%:50%) 20nm | LiQ 1nm |
| E3 | B | M1:MA2:D2 (90%:5%:5%) 30nm | ST1:LiQ (50%:50%) 20nm | LiQ 1nm |
| E4 | C | M1:MA1 :D2 (90%:5%:5%) 30nm | ST1:LiQ (50%:50%) 20nm | LiQ 1nm |
| E5 | C | M1:MA2:D2 (90%:5%:5%) 30nm | ST1:LiQ (50%:50%) 20nm | LiQ 1nm |
| E6 | C | M1:MA1:TBP (91%:7%:2%) 30nm | ST1:LiQ (50%:50%) 20nm | LiQ 1nm |
| E7 | C | M1:MA2:TBP (91%:7%:2%) 30nm | ST1:LiQ (50%:50%) 20nm | LiQ 1nm |

**Tabelle 2: Daten der OLEDs**

| Bsp. | U1000 (V) | SE1000 (cd/A) | LE1000 (lm/W) | EQE 1000 | CIE x/y bei 1000 cd/m² | L0 | L1 % | LD (h) |
|---|---|---|---|---|---|---|---|---|
| V1 | 5.5 | 6.3 | 3.6 | 6.3% | 0.14/0.11 | 6000 cd/m² | 70 | 140 |
| V2 | 4.5 | 8.0 | 5.6 | 7.4% | 0.14/0.13 | 6000 cd/m² | 70 | 170 |
| V3 | 4.8 | 5.7 | 3.7 | 4.2% | 0.15/0.18 | 6000 cd/m² | 70 | 60 |
| V4 | 4.4 | 8.4 | 6.0 | 7.7% | 0.14/0.13 | 6000 cd/m² | 70 | 180 |
| V5 | 4.8 | 6.0 | 4.0 | 4.5% | 0.15/0.17 | 6000 cd/m² | 70 | 55 |
| V6 | 4.2 | 7.5 | 5.5 | 6.8% | 0.15/0.14 | 6000 cd/m² | 70 | 150 |
| V7 | 4.5 | 9.2 | 4.5 | 6.0% | 0.14/0.21 | 6000 cd/m² | 70 | 130 |
| E1 | 5.3 | 6.6 | 3.9 | 6.9% | 0.15/0.10 | 6000 cd/m² | 70 | 200 |
| E2 | 4.5 | 8.6 | 6.1 | 7.9% | 0.14/0.13 | 6000 cd/m² | 70 | 190 |
| E3 | 4.5 | 8.5 | 5.9 | 7.8% | 0.14/0.13 | 6000 cd/m² | 70 | 185 |
| E4 | 4.4 | 8.6 | 6.1 | 8.0% | 0.14/0.13 | 6000 cd/m² | 70 | 220 |
| E5 | 4.3 | 8.7 | 6.3 | 8.1% | 0.14/0.13 | 6000 cd/m² | 70 | 235 |
| E6 | 4.3 | 10 | 7.2 | 6.7% | 0.14/0.20 | 6000 cd/m² | 70 | 180 |
| E7 | 4.4 | 9.9 | 7.1 | 6.9% | 0.14/0.20 | 6000 cd/m² | 70 | 195 |

**Tabelle 3: Strukturformeln der Materialien für die OLEDs**

| | |
|---|---|
| 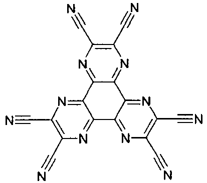 | 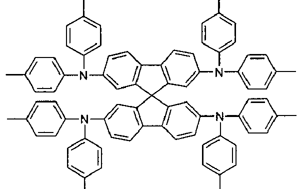 |
| HATCN | SpA1 |
| 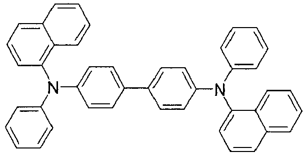 | 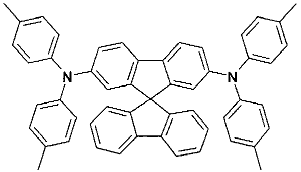 |
| NPB | SpA2 |
| 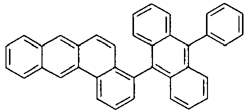 | 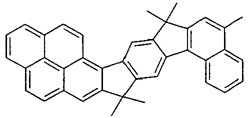 |
| M1 | D1 |
| 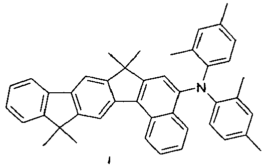 | 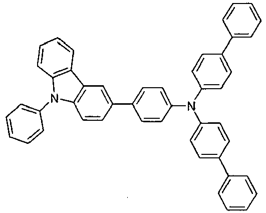 |
| D2 | CbzA1 |
| 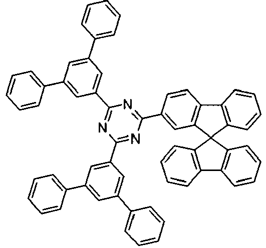 | 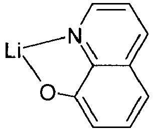 |
| ST1 | LiQ |
| 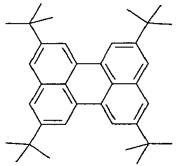 | 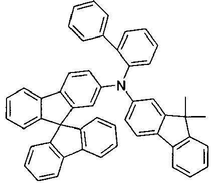 |
| TBP | MA1 |
| 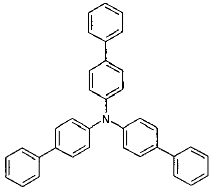 | |
| MA2 | |

## Patentansprüche

1. Elektronische Vorrichtung, enthaltend Anode, Kathode, sowie mindestens eine emittierende Schicht, wobei die emittierende Schicht mindestens einen Dotanden D, mindestens ein Matrixmaterial M1 und mindestens ein Matrixmaterial M2 enthält, wobei D, M1 und M2 unterschiedlich gewählt sind und wobei M1 gewählt ist aus Mono-Triarylaminen und M2 gewählt ist aus Verbindungen enthaltend mindestens eine Anthraceneinheit oder aus Verbindungen enthaltend mindestens eine Pyreneinheit, und wobei M1 keine kondensierte Arylgruppe mit mehr als 10 aromatischen Ringatomen enthält.

2. Elektronische Vorrichtung nach Anspruch 1, **dadurch gekennzeichnet, dass** der Dotand D eine fluoreszierende emittierende Verbindung ist.

3. Elektronische Vorrichtung nach Anspruch 1 oder 2, **dadurch gekennzeichnet, dass** die emittierende Schicht der Vorrichtung Licht mit einem Emissionsmaximum bei einer Wellenlänge von 430 nm bis 480 nm emittiert.

4. Elektronische Vorrichtung nach einem oder mehreren der Ansprüche 1 bis 3, **dadurch gekennzeichnet, dass** anodenseitig von der emittierenden Schicht eine lochtransportierende Schicht enthaltend eine oder mehrere Mono-Triarylamin-Verbindungen vorhanden ist.

5. Elektronische Vorrichtung nach einem oder mehreren der Ansprüche 1 bis 4, **dadurch gekennzeichnet, dass** der Dotand D in der emittierenden Schicht in einem Anteil von 0.5 - 10 Vol.-% vorhanden ist.

6. Elektronische Vorrichtung nach einem oder mehreren der Ansprüche 1 bis 5, **dadurch gekennzeichnet, dass** das Matrixmaterial M1 in der emittierenden Schicht in einem Anteil von 1 - 15 Vol-% vorhanden ist.

7. Elektronische Vorrichtung nach einem oder mehreren der Ansprüche 1 bis 6, **dadurch gekennzeichnet, dass** das Matrixmaterial M1 der Formel (I) 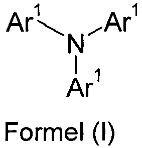 entspricht, wobei gilt:
Ar¹ ist bei jedem Auftreten gleich oder verschieden ein aromatisches oder heteroaromatisches Ringsystem mit 5 bis 40 aromatischen Ringatomen, das mit einem oder mehreren Resten R¹ substituiert sein kann; und
R¹ ist bei jedem Auftreten gleich oder verschieden H, D, F, C(=O)R², CN, Si(R²)₃, P(=O)(R²)₂, S(=O)R², S(=O)₂R², eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten R² substituiert sein können und wobei eine oder mehrere CH₂-Gruppen in den oben genannten Gruppen durch -R²C=CR²-, -C≡C-, Si(R²)₂, C=O, C=S, C=NR², -C(=O)O-, -C(=O)NR²-, P(=O)(R²), -O-,-S-, SO oder SO₂ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste R² substituiert sein kann, oder eine Aryloxy- oder Heteroaryloxygruppe mit 5 bis 30 aromatischen Ringatomen, die durch einen oder mehrere Reste R² substituiert sein kann, wobei zwei oder mehr Reste R¹ miteinander verknüpft sein können und einen Ring bilden können;
R² ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R² miteinander verknüpft sein und einen Ring bilden.

8. Elektronische Vorrichtung nach einem oder mehreren der Ansprüche 1 bis 7, **dadurch gekennzeichnet, dass** das Matrixmaterial M2 der Formel (II) entspricht 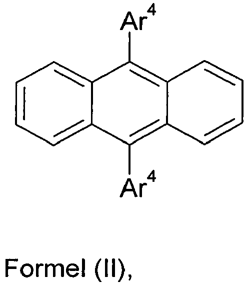 wobei gilt:
Ar⁴ ist bei jedem Auftreten gleich oder verschieden ein aromatisches oder heteroaromatisches Ringsystem mit 5 bis 40 aromatischen Ringatomen, das mit einem oder mehreren Resten R³ substituiert sein kann; und
R³ ist bei jedem Auftreten gleich oder verschieden H, D, F, C(=O)R⁴, CN, Si(R⁴)₃, N(R⁴)₂, P(=O)(R⁴)₂, S(=O)R⁴, S(=O)₂R⁴, eine geradkettige Alkyl- oder Alkoxygruppe mit 1 bis 20 C-Atomen oder eine verzweigte oder cyclische Alkyl- oder Alkoxygruppe mit 3 bis 20 C-Atomen oder eine Alkenyl- oder Alkinylgruppe mit 2 bis 20 C-Atomen, wobei die oben genannten Gruppen jeweils mit einem oder mehreren Resten R⁴ substituiert sein können und wobei eine oder mehrere CH₂-Gruppen in den oben genannten Gruppen durch-R⁴C=CR⁴-, -C≡C-, Si(R⁴)₂, C=O, C=S, C=NR⁴, -C(=O)O-, -C(=O)NR⁴-, NR⁴, P(=O)(R⁴), -O-, -S-, SO oder SO₂ ersetzt sein können und wobei ein oder mehrere H-Atome in den oben genannten Gruppen durch D, F oder CN ersetzt sein können, oder ein aromatisches oder heteroaromatisches Ringsystem mit 5 bis 30 aromatischen Ringatomen, das jeweils durch einen oder mehrere Reste R⁴ substituiert sein kann, oder eine Aryloxy- oder Heteroaryloxygruppe mit 5 bis 30 aromatischen Ringatomen, die durch einen oder mehrere Reste R⁴ substituiert sein kann, wobei zwei oder mehr Reste R³ miteinander verknüpft sein können und einen Ring bilden können;
R⁴ ist bei jedem Auftreten gleich oder verschieden H, D, F oder ein aliphatischer, aromatischer oder heteroaromatischer organischer Rest mit 1 bis 20 C-Atomen, in dem auch ein oder mehrere H-Atome durch D oder F ersetzt sein können; dabei können zwei oder mehr Substituenten R⁴ miteinander verknüpft sein und einen Ring bilden; und
das Anthracen an allen freien Positionen mit einer Gruppe R³ substituiert sein kann.

9. Elektronische Vorrichtung nach einem oder mehreren der Ansprüche 1 bis 8, gewählt aus organischen integrierten Schaltungen (OICs), organischen Feld-Effekt-Transistoren (OFETs), organischen Dünnfilmtransistoren (OTFTs), organischen lichtemittierenden Transistoren (OLETs), organischen Solarzellen (OSCs), organischen optischen Detektoren, organischen Photorezeptoren, organischen Feld-Quench-Devices (OFQDs), organischen lichtemittierenden elektrochemischen Zellen (OLECs), organischen Laserdioden (O-Laser) und organischen Elektrolumineszenzvorrichtungen (OLEDs).

10. Elektronische Vorrichtung nach einem oder mehreren der Ansprüche 1 bis 9, **dadurch gekennzeichnet, dass** die emittierende Schicht aus Lösung aufgebracht wird.

11. Verwendung einer elektronischen Vorrichtung nach einem oder mehreren der Ansprüche 1 bis 10 in Displays, als Lichtquelle in Beleuchtungsanwendungen oder als Lichtquelle in medizinischen und/oder kosmetischen Anwendungen.

12. Formulierung, enthaltend mindestens ein organisches Lösungsmittel, mindestens einen Dotanden D, mindestens ein Matrixmaterial M1 und mindestens ein Matrixmaterial M2, wobei D, M1 und M2 unterschiedlich gewählt sind und wobei M1 gewählt ist aus Mono-Triarylaminen und M2 gewählt ist aus Verbindungen enthaltend mindestens eine Anthraceneinheit oder aus Verbindungen enthaltend mindestens eine Pyreneinheit, und wobei M1 keine kondensierte Arylgruppe mit mehr als 10 aromatischen Ringatomen enthält.

13. Verwendung einer Formulierung nach Anspruch 12 zur Herstellung einer organischen Elektrolumineszenzvorrichtung.

## Claims

1. Electronic device comprising anode, cathode, and at least one emitting layer, where the emitting layer comprises at least one dopant D, at least one matrix material M1 and at least one matrix material M2, where D, M1 and M2 are selected differently and where M1 is selected from monotriarylamines and M2 is selected from compounds containing at least one anthracene unit or from compounds containing at least one pyrene unit, and where M1 does not contain a condensed aryl group having more than 10 aromatic ring atoms.

2. Electronic device according to Claim 1, **characterised in that** the dopant D is a fluorescent emitting compound.

3. Electronic device according to Claim 1 or 2, **characterised in that** the emitting layer of the device emits light having an emission maximum at a wavelength of 430 nm to 480 nm.

4. Electronic device according to one or more of Claims 1 to 3, **characterised in that** a hole-transporting layer comprising one or more monotriarylamine compounds is present on the anode side of the emitting layer.

5. Electronic device according to one or more of Claims 1 to 4, **characterised in that** the dopant D is present in the emitting layer in a proportion of 0.5 - 10% by vol.

6. Electronic device according to one or more of Claims 1 to 5, **characterised in that** the matrix material M1 is present in the emitting layer in a proportion of 1 - 15% by vol.

7. Electronic device according to one or more of Claims 1 to 6, **characterised in that** the matrix material M1 conforms to the formula (I) 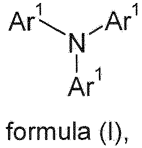 where:
Ar¹ is on each occurrence, identically or differently, an aromatic or heteroaromatic ring system having 5 to 40 aromatic ring atoms, which may be substituted by one or more radicals R¹; and
R¹ is on each occurrence, identically or differently, H, D, F, C(=O)R², CN, Si(R²)₃, P(=O)(R²)₂, S(=O)R², S(=O)₂R², a straight-chain alkyl or alkoxy group having 1 to 20 C atoms or a branched or cyclic alkyl or alkoxy group having 3 to 20 C atoms or an alkenyl or alkynyl group having 2 to 20 C atoms, where the above-mentioned groups may in each case be substituted by one or more radicals R² and where one or more CH₂ groups in the above-mentioned groups may be replaced by -R²C=CR²-, -C≡C-, Si(R²)₂, C=O, C=S, C=NR², -C(=O)O-, -C(=O)NR²-, P(=O)(R²), -O-, -S-, SO or SO₂ and where one or more H atoms in the above-mentioned groups may be replaced by D, F or CN, or an aromatic or heteroaromatic ring system having 5 to 30 aromatic ring atoms, which may in each case be substituted by one or more radicals R², or an aryloxy or heteroaryloxy group having 5 to 30 aromatic ring atoms, which may be substituted by one or more radicals R², where two or more radicals R¹ may be linked to one another and may form a ring;
R² is on each occurrence, identically or differently, H, D, F or an aliphatic, aromatic or heteroaromatic organic radical having 1 to 20 C atoms, in which, in addition, one or more H atoms may be replaced by D or F; two or more substituents R² may be linked to one another and may form a ring.

8. Electronic device according to one or more of Claims 1 to 7, **characterised in that** the matrix material M2 conforms to the formula (II) 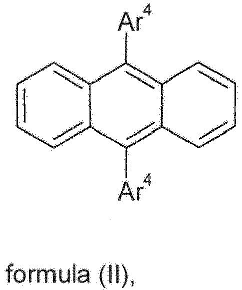 where:
Ar⁴ is on each occurrence, identically or differently, an aromatic or heteroaromatic ring system having 5 to 40 aromatic ring atoms, which may be substituted by one or more radicals R³; and
R³ is on each occurrence, identically or differently, H, D, F, C(=O)R⁴, CN, Si(R⁴)₃, N(R⁴)₂, P(=O)(R⁴)₂, S(=O)R⁴, S(=O)₂R⁴, a straight-chain alkyl or alkoxy group having 1 to 20 C atoms or a branched or cyclic alkyl or alkoxy group having 3 to 20 C atoms or an alkenyl or alkynyl group having 2 to 20 C atoms, where the above-mentioned groups may in each case be substituted by one or more radicals R⁴ and where one or more CH₂ groups in the above-mentioned groups may be replaced by -R⁴C=CR⁴-, -C≡C-, Si(R⁴)₂, C=O, C=S, C=NR⁴, -C(=O)O-, -C(=O)NR⁴-, NR⁴, P(=O)(R⁴), -O-, -S-, SO or SO₂ and where one or more H atoms in the above-mentioned groups may be replaced by D, F or CN, or an aromatic or heteroaromatic ring system having 5 to 30 aromatic ring atoms, which may in each case be substituted by one or more radicals R⁴, or an aryloxy or heteroaryloxy group having 5 to 30 aromatic ring atoms, which may be substituted by one or more radicals R⁴, where two or more radicals R³ may be linked to one another and may form a ring;
R⁴ is on each occurrence, identically or differently, H, D, F or an aliphatic, aromatic or heteroaromatic organic radical having 1 to 20 C atoms, in which, in addition, one or more H atoms may be replaced by D or F; two or more substituents R⁴ may be linked to one another and may form a ring; and
the anthracene may be substituted at all free positions by a group R³.

9. Electronic device according to one or more of Claims 1 to 8, selected from organic integrated circuits (OICs), organic field-effect transistors (OFETs), organic thin-film transistors (OTFTs), organic light-emitting transistors (OLETs), organic solar cells (OSCs), organic optical detectors, organic photoreceptors, organic field-quench devices (OFQDs), organic light-emitting electrochemical cells (OLECs), organic laser diodes (O-lasers) and organic electroluminescent devices (OLEDs).

10. Electronic device according to one or more of Claims 1 to 9, **characterised in that** the emitting layer is applied from solution.

11. Use of an electronic device according to one or more of Claims 1 to 10 in displays, as light source in lighting applications or as light source in medical and/or cosmetic applications.

12. Formulation comprising at least one organic solvent, at least one dopant D, at least one matrix material M1 and at least one matrix material M2, where D, M1 and M2 are selected differently and where M1 is selected from monotriarylamines and M2 is selected from compounds containing at least one anthracene unit or from compounds containing at least one pyrene unit, and where M1 does not contain a condensed aryl group having more than 10 aromatic ring atoms.

13. Use of a formulation according to Claim 12 for the production of an organic electroluminescent device.

## Revendications

1. Dispositif électronique comprenant une anode, une cathode et au moins une couche d'émission, dans lequel la couche d'émission comprend au moins un dopant D, au moins un matériau de matrice M1 et au moins un matériau de matrice M2, dans lequel D, M1 et M2 sont sélectionnés de manière différente et dans lequel M1 est sélectionné parmi les monotriarylamines et M2 est sélectionné parmi les composés qui contiennent au moins une unité anthracène ou parmi les composés qui contiennent au moins une unité pyrène, et dans lequel M1 ne contient pas un groupe aryle condensé qui comporte plus de 10 atomes de cycle aromatique.

2. Dispositif électronique selon la revendication 1, **caractérisé en ce que** le dopant D est un composé d'émission fluorescent.

3. Dispositif électronique selon la revendication 1 ou 2, **caractérisé en ce que** la couche d'émission du dispositif émet une lumière qui présente un maximum d'émission à une longueur d'onde de 430 nm à 480 nm.

4. Dispositif électronique selon une ou plusieurs des revendications 1 à 3, **caractérisé en ce qu'**une couche de transport de trous qui comprend un ou plusieurs composé(s) monotriarylamine est présente sur le côté d'anode de la couche d'émission.

5. Dispositif électronique selon une ou plusieurs des revendications 1 à 4, **caractérisé en ce que** le dopant D est présent dans la couche d'émission selon une proportion de 0,5 - 10% en volume.

6. Dispositif électronique selon une ou plusieurs des revendications 1 à 5, **caractérisé en ce que** le matériau de matrice M1 est présent dans la couche d'émission selon une proportion de 1 - 15% en volume.

7. Dispositif électronique selon une ou plusieurs des revendications 1 à 6, **caractérisé en ce que** le matériau de matrice M1 est conforme à la formule (I) : 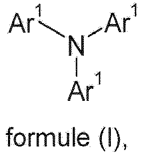 dans laquelle :
Ar¹ est pour chaque occurrence, de manière identique ou différente, un système de cycle aromatique ou hétéroaromatique qui comporte de 5 à 40 atomes de cycle aromatique, lequel peut être substitué par un radical ou par plusieurs radicaux R¹ ; et
R¹ est pour chaque occurrence, de manière identique ou différente, H, D, F, C(=O)R², CN, Si(R²)₃, P(=O)(R²)₂, S(=O)R², S(=O)₂R², un groupe alkyle ou alcoxy en chaîne droite qui comporte de 1 à 20 atome(s) de C ou un groupe alkyle ou alcoxy ramifié ou cyclique qui comporte de 3 à 20 atomes de C ou un groupe alkényle ou alkynyle qui comporte de 2 à 20 atomes de C, où les groupes qui ont été mentionnés ci-avant peuvent dans chaque cas être substitués par un radical ou par plusieurs radicaux R² et où un ou plusieurs groupe(s) CH₂ dans les groupes qui ont été mentionnés ci-avant peut/ peuvent être remplacé(s) par -R²C=CR²-, -C≡C-, Si(R²)₂, C=O, C=S, C=NR², -C(=O)O-, -C(=O)NR²-, P(=O)(R²), -O-, -S-, SO ou SO₂ et où un ou plusieurs atome(s) de H dans les groupes qui ont été mentionnés ci-avant peut/peuvent être remplacé(s) par D, F ou CN, ou un système de cycle aromatique ou hétéroaromatique qui comporte de 5 à 30 atomes de cycle aromatique, lequel peut dans chaque cas être substitué par un radical ou par plusieurs radicaux R², ou un groupe aryloxy ou hétéroaryloxy qui comporte de 5 à 30 atomes de cycle aromatique, lequel peut être substitué par un radical ou par plusieurs radicaux R², où deux radicaux R¹ ou plus peuvent être liés l'un à l'autre ou les uns aux autres et peuvent former un cycle ;
R² est pour chaque occurrence, de manière identique ou différente, H, D, F ou un radical organique aliphatique, aromatique ou hétéroaromatique qui comporte de 1 à 20 atome(s) de C, où, en outre, un ou plusieurs atome(s) de H peut/peuvent être remplacé(s) par D ou F ; deux substituants R² ou plus peuvent être liés l'un à l'autre ou les uns aux autres et peuvent former un cycle.

8. Dispositif électronique selon une ou plusieurs des revendications 1 à 7, **caractérisé en ce que** le matériau de matrice M2 est conforme à la formule (II) : 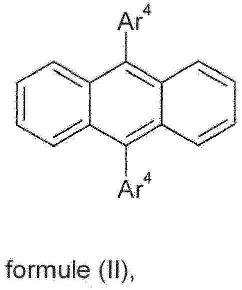 dans laquelle :
Ar⁴ est pour chaque occurrence, de manière identique ou différente, un système de cycle aromatique ou hétéroaromatique qui comporte de 5 à 40 atomes de cycle aromatique, lequel peut être substitué par un radical ou par plusieurs radicaux R³; et
R³ est pour chaque occurrence, de manière identique ou différente, H, D, F, C(=O)R⁴, CN, Si(R⁴)₃, N(R⁴)₂, P(=O)(R⁴)₂, S(=O)R⁴, S(=O)₂R⁴, un groupe alkyle ou alcoxy en chaîne droite qui comporte de 1 à 20 atome(s) de C ou un groupe alkyle ou alcoxy ramifié ou cyclique qui comporte de 3 à 20 atomes de C ou un groupe alkényle ou alkynyle qui comporte de 2 à 20 atomes de C, où les groupes qui ont été mentionnés ci-avant peuvent dans chaque cas être substitués par un radical ou par plusieurs radicaux R⁴ et où un ou plusieurs groupe(s) CH₂ dans les groupes qui ont été mentionnés ci-avant peut/peuvent être remplacé(s) par -R⁴C=CR⁴-, -C≡C-, Si(R⁴)₂, C=O, C=S, C=NR⁴, -C(=O)O-, -C(=O)NR⁴-, NR⁴, P(=O)(R⁴), -O-, -S-, SO ou SO₂ et où un ou plusieurs atome(s) de H dans les groupes qui ont été mentionnés ci-avant peut/peuvent être remplacé(s) par D, F ou CN, ou un système de cycle aromatique ou hétéroaromatique qui comporte de 5 à 30 atomes de cycle aromatique, lequel peut dans chaque cas être substitué par un radical ou par plusieurs radicaux R⁴, ou un groupe aryloxy ou hétéroaryloxy qui comporte de 5 à 30 atomes de cycle aromatique, lequel peut être substitué par un radical ou par plusieurs radicaux R⁴, où deux radicaux R³ ou plus peuvent être liés l'un à l'autre ou les uns aux autres et peuvent former un cycle ;
R⁴ est pour chaque occurrence, de manière identique ou différente, H, D, F ou un radical organique aliphatique, aromatique ou hétéroaromatique qui comporte de 1 à 20 atome(s) de C, où, en outre, un ou plusieurs atome(s) de H peut/peuvent être remplacé(s) par D ou F ; deux substituants R⁴ ou plus peuvent être liés l'un à l'autre ou les uns aux autres et peuvent former un cycle ; et
l'anthracène peut être substitué au niveau de toutes les positions libres par un groupe R³.

9. Dispositif électronique selon une ou plusieurs des revendications 1 à 8, sélectionné parmi les circuits intégrés organiques (OIC), les transistors à effet de champ organiques (OFET), les transistors à film mince organiques (OTFT), les transistors à émission de lumière ou luminescents organiques (OLET), les cellules solaires organiques (OSC), les détecteurs optiques organiques, les photorécepteurs organiques, les dispositifs à extinction de champ organiques (OFQD), des cellules électrochimiques à émission de lumière ou luminescentes organiques (OLEC), les diodes laser organiques (O-laser) et les dispositifs électroluminescents organiques (OLED).

10. Dispositif électronique selon une ou plusieurs des revendications 1 à 9, **caractérisé en ce que** la couche d'émission est appliquée à partir d'une solution.

11. Utilisation d'un dispositif électronique selon une ou plusieurs des revendications 1 à 10 dans des affichages, en tant que source de lumière dans des applications d'éclairage ou en tant que source de lumière dans des applications médicales et/ou cosmétiques.

12. Formulation comprenant au moins un solvant organique, au moins un dopant D, au moins un matériau de matrice M1 et au moins un matériau de matrice M2, dans laquelle D, M1 et M2 sont sélectionnés de façon différente et dans laquelle M1 est sélectionné parmi les monotriarylamines et M2 est sélectionné parmi les composés qui contiennent au moins une unité anthracène ou parmi les composés qui contiennent au moins une unité pyrène, et dans laquelle M1 ne contient pas un groupe aryle condensé qui comporte plus de 10 atomes de cycle aromatique.

13. Utilisation d'une formulation selon la revendication 12 pour la production d'un dispositif électroluminescent organique.
